# EUROPEAN PATENT APPLICATION

(11) **EP 1 863 323 A1**
(43) Date of publication of application: **05.12.2007**
(21) Application number: 06729008.0
(22) Date of filing: 14.03.2006
(51) Int. Cl.: H05B 33/12, H01L 51/50

(54) **COLOR CONVERSION SUBSTRATE, METHOD FOR MANUFACTURING SAME AND LIGHT-EMITTING DEVICE**

(30) Priority: 22.03.2005 JP 2005081222
(71) Applicant: IDEMITSU KOSAN CO., LTD., Tokyo 100-8321 (JP)
(72) Inventor: EIDA, Mitsuru, Chiba, 2990293 (JP); HACHIYA, Satoshi, Chiba, 2990293 (JP); KATANO, Junichi, Chiba, 2990293 (JP)
(74) Representative: Gille Hrabal Struck Neidlein Prop Roos
(86) International application number: PCT/JP2006/304943
(87) International publication number: WO 2006/100957

(57) **Abstract**

A color conversion substrate including a first fluorescent layer 2a emitting first fluorescence and a second fluorescent layer 2b emitting second fluorescence on a supporting substrate 1, and the first fluorescent layer 2a including an organic fluorescent material and the second fluorescent layer 2b comprising a semiconductor nanocrystal.

## Description

### Technical Field

The invention relates to a color conversion substrate, a method for producing the color conversion substrate, and an emitting apparatus. More particularly, the invention relates to a color conversion substrate using a fluorescent layer including an organic fluorescent material and a fluorescent layer including a semiconductor nanocrystal.

### Background Art

A color conversion substrate which converts the wavelength of light emitted from a light source using a fluorescent material has been applied in various fields such as the electronic display field.
For example, a technology has been disclosed which converts light emitted from a blue emitting device into green light and red light using fluorescent material layers to emit light of blue, green, and red (i.e. three primary colors), thereby achieving a full color display (see patent documents 1 to 3, for example).

According to the above method, since a single-color emitting device can be used, it is unnecessary to selectively apply an emitting material, differing from a multicolor emitting device. This allows utilization of a small film forming device and reduces the amount of emitting material used.
Since the color conversion substrate can be formed by utilizing widely-used photolithography, printing, or the like, a large-screen high-resolution display can be easily mass-produced.
The above method also has an advantage in that a stable emitting device can be used in comparison with a method (CF method) which achieves a full color display by combining a white emitting device and a color filter. Moreover, the above method achieves high efficiency due to utilization of fluorescence.
In addition, a white emitting apparatus (e.g. liquid crystal backlight or lighting device) can be formed by using the above method. A white emitting apparatus exhibiting excellent durability (i.e. emitting device shows a small change in color) can be easily obtained by stacking a single-color or two-color emitting device (e.g. blue and blue green) and a fluorescent material layer (patent document 1 and non-patent document 1).

An organic fluorescent material and an inorganic fluorescent material have been studied as the fluorescent material for forming the fluorescent layer of the color conversion substrate.
A fluorescent dye and a fluorescent pigment have been studied as the organic fluorescent material. As the inorganic fluorescent material, a material of a metal oxide, sulfide, or the like doped with a transition metal ion, a material of a metal chalcogenide doped with a transition metal ion, and a material utilizing the band gap of a semiconductor (semiconductor nanocrystal) have been studied. In particular, the fluorescent dye, fluorescent pigment (organic fluorescent material), and a semiconductor nanocrystal (inorganic fluorescent material) can be given to absorb light emitted from an emitting device and emit intense green or red fluorescence.

The semiconductor nanocrystal is formed by forming a semiconductor into ultrafine particle (diameter: 10 nm or less) to exhibit specific light absorption/emission characteristics due to electron confinement effects (quantum size effects). The semiconductor nanocrystal (inorganic material) have the following features.
(a) Stable against heat and light (highly durable)
(b) Free from concentration quenching
(c) High fluorescence quantum yield (high device efficiency)
(d) No light scattering because of being ultrafine particles (high contrast)
(e) Adjustable to emit sharp fluorescence at an arbitrary wavelength by changing the particle size (wide color variety and high efficiency)

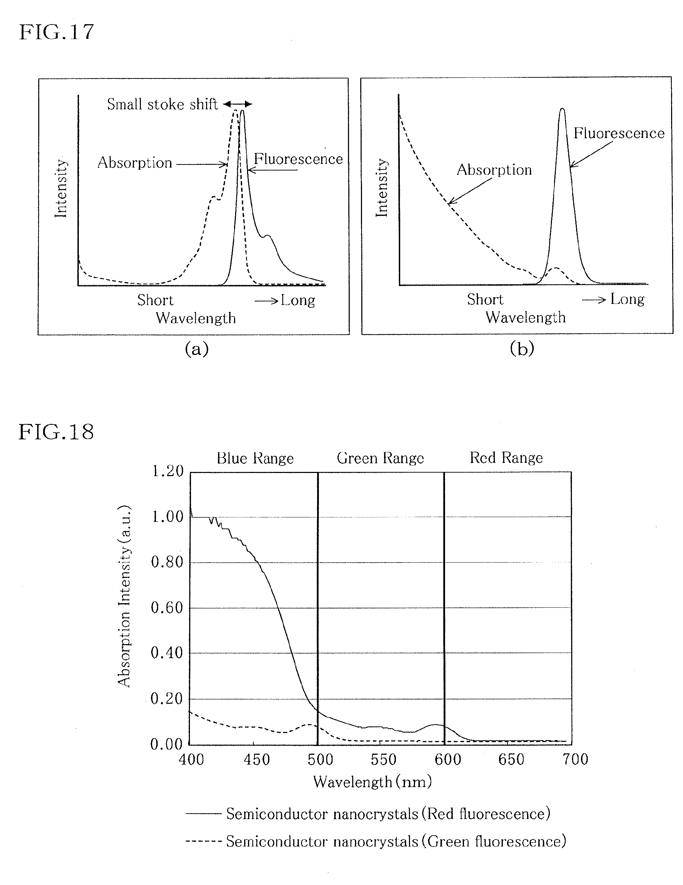

The patent documents 1 to 3 disclose color conversion substrates in which organic fluorescent materials are used for a green fluorescent layer and a red fluorescent layer.
Patent document 4 discloses a color conversion substrate in which semiconductor nanocrystals are used for a green fluorescent layer and a red fluorescent layer.
When converting light from a blue emitting device (including blue green) into red light, using an organic fluorescent material, since the organic fluorescent material generally has a small Stokes shift (difference in wavelength between absorption peak and fluorescence peak, see FIG. 17(a)), the blue light is converted into red light by causing energy transfer by combining a blue-to-green conversion material and a green-to-red conversion material (see patent document 5, for example).
However, since concentration quenching occurs due to an increase in the concentration of the fluorescent material, the conversion efficiency into red light is decreased and the red purity is decreased.

On the other hand, when converting light from a blue emitting device (including blue green) into green light using semiconductor nanocrystal, since the wavelength region in which the light emitted from the emitting device is absorbed to a large extent significantly differs from the fluorescence peak wavelength (see FIG. 17(b)), the optimum absorption region occurs at a wavelength shorter than that of the blue region (i.e. UV region) (see FIG. 18). Specifically, since the semiconductor nanocrystal cannot sufficiently absorb the light emitted from the emitting device which emits light in the blue region, but allow the light emitted from the emitting device to pass through, the conversion efficiency into green light is decreased and the green purity is decreased.

As described above, an emitting apparatus including a blue emitting device and a color conversion substrate in which organic fluorescent materials are used for a green fluorescent layer and a red fluorescent layer exhibits a relatively weak red emission, whereby the white balance is impaired. Specifically, this emitting apparatus produces a blue-greenish white display (when blue, red, and green pixels are turned on). When continuously displaying a white image by adjusting the luminance of the emitting device corresponding to each color, the load imposed on the emitting device corresponding to red is increased, whereby the emitting apparatus shows nonuniform deterioration or image burn.

On the other hand, an emitting apparatus including a blue emitting device and a color conversion substrate in which semiconductor nanocrystals are used for a green fluorescent layer and a red fluorescent layer exhibits a relatively weak green emission, whereby the white balance is impaired. Specifically, this emitting apparatus produces a purplish white display. When continuously displaying a white image by adjusting the luminance of the emitting device corresponding to each color, the load imposed on the emitting device corresponding to green is increased, whereby the emitting apparatus shows nonuniform deterioration or image burn.

When using a white emitting device ("blue + orange to red" or "blue green + orange to red"), orange to red light emitted from the emission device can be utilized as emission from the emitting apparatus. However, an emitting apparatus including a white emitting device and a color conversion substrate using organic fluorescent materials for a green fluorescent layer and a red fluorescent layer exhibits relatively weak blue emission, whereby the white balance is impaired. Specifically, this emitting apparatus produces a yellowish white display. When continuously displaying a white image by adjusting the luminance of the emitting device corresponding to each color, the load imposed on the emitting device corresponding to blue is increased, whereby the emitting apparatus shows nonuniform deterioration or image burn.

An emitting apparatus including a white emitting device and a color conversion substrate using semiconductor nanocrystals for a green fluorescent layer and a red fluorescent layer exhibits a relatively strong red emission, whereby the white balance is impaired. Specifically, this emitting apparatus produces a reddish white display. When continuously displaying a white image by adjusting the luminance of the emitting device corresponding to each color, the load imposed on the emitting devices corresponding to blue and green is increased, whereby the emitting apparatus shows nonuniform deterioration or image burn.

Therefore, a known color conversion substrate requires adjustment of the emission color of the emitting device corresponding to each color conversion substrate (e.g. three-wavelength emission of blue, green, and red). However, it is difficult to adjust the emission color of the emitting device, since the device configuration becomes complicated and the drive characteristics (current-voltage-luminance characteristics) and durability (e.g. stability and high-temperature drive characteristics) of the device must be improved.
A material with a higher absorption coefficient may be selected as semiconductor nanocrystal used in a green fluorescent layer. However, when using semiconductor nanocrystals of which the particle size must be strictly controlled as red and green fluorescent materials, the quality of the color conversion substrate may become unstable, or the cost of the color conversion substrate may be increased.
As a known white emitting apparatus, a white emitting apparatus has been disclosed which includes a blue emitting device and a stacked body of an organic fluorescent material layer (perylene) and an inorganic fluorescent material layer (Y(Gd)AG:Ce (material obtained by doping metal oxide, sulfide, or the like with transition metal ion)) (non-patent document 1).
According to the emitting apparatus having this configuration, since the inorganic fluorescent material has a large particle size, light emitted from the emitting device and fluorescence undergo a significant scattering loss, whereby an efficient white emitting apparatus cannot be obtained.

[Patent document 1] JP-A-3-152897
[Patent document 2] JP-A-5-258860
[Patent document 3] WO98/3443
[Patent document 4] United States Patent No. 6,608,439
[Patent document 5] JP-A-8-286033
[Non-patent document 1] Appl. Phys. Lett., Vol. 80, No. 19, 3470 (2002)

### DISCLOSURE OF THE INVENTION

The invention was achieved in view of the above-described problems. An object of the invention is to provide a color conversion type multicolor emitting apparatus which exhibits an excellent white balance and excellent durability, a color conversion substrate used for the multicolor emitting apparatus, and a method for producing the color conversion substrate. Another object of the invention is to provide a white emitting apparatus which exhibits high efficiency and excellent emission uniformity, and a color conversion substrate used for the same.

The inventors of the invention conducted extensive studies in order to achieve the above objects. As a result, the inventors have found that an emitting apparatus using a color conversion substrate in which a fluorescent layer including an organic fluorescent material and a fluorescent layer including a semiconductor nanocrystal are formed on the same substrate exhibits an excellent white balance and excellent durability. This finding has led to the completion of the invention.
According to the invention, a color conversion substrate, a method for producing the same, and an emitting apparatus given below are provided.

1. A color conversion substrate including a first fluorescent layer emitting first fluorescence and a second fluorescent layer emitting second fluorescence on a supporting substrate, and the first fluorescent layer comprising an organic fluorescent material and the second fluorescent layer including a semiconductor nanocrystal.
2. The color conversion substrate according to 1 wherein the first fluorescent layer is a green fluorescent layer and the second fluorescent layer is a red fluorescent layer.
3. The color conversion substrate according to 1 or 2 wherein the first fluorescent layer and the second fluorescent layer are separately arranged in a plane on the supporting substrate.
4. The color conversion substrate according to 3 including a blue color filter layer between the first fluorescent layer and the second fluorescent layer on the supporting layer.
5. The color conversion substrate according to 3 or 4 including a black matrix between the first fluorescent layer and the second fluorescent layer, or between the blue color filter layer, the first fluorescent layer, and the second fluorescent layer.
6. The color conversion substrate according to 1 or 2 wherein the first fluorescent layer and the second fluorescent layer are stacked on the supporting substrate.
7. The color conversion substrate according to any one of 1 to 6 wherein the organic fluorescent material of the first fluorescent layer comprises a perylene dye.
8. The color conversion layer according to any one of 1 to 7 wherein the first fluorescent layer includes the organic fluorescent material dispersed in a transparent medium having no ethylenic unsaturated bonds.
9. The color conversion substrate according to 8 wherein the organic fluorescent material includes a coumarin dye.
10. The color conversion layer according to 1 to 9 wherein at least one of the first fluorescent layer and the second fluorescent layer, and a color filter are stacked.
11. An emitting apparatus wherein an emitting device is stacked on at least one of the first fluorescent layer and the second fluorescent layer, and the blue color filter layer on the color conversion substrate of any one of 1 to 10.
12. An emitting apparatus wherein the color conversion substrate of any one of 1 to 10 faces and is attached to an emitting device substrate with an emitting device arranged on a substrate.
13. An emitting apparatus containing at least a first pixel and a second pixel on a supporting substrate, the first pixel containing a first emitting device and a first fluorescent layer emitting a first fluorescence arranged in this order, the first fluorescent layer containing an organic fluorescent material, the second pixel containing a second emitting device and a second fluorescent layer emitting a second fluorescence arranged in this order, the second fluorescent layer containing a semiconductor nanocrystal.
14. The emitting apparatus according to any one of 11 to 13 wherein the emitting device has an emission peak in a blue region.
15. The emitting apparatus according to any one of 11 to 14 wherein the emitting device is an organic electroluminescent device.
16. A method for producing the color conversion substrate of any one of 1 to 10 having the steps of: forming a second fluorescent layer, and then forming a first fluorescent layer.
17. The method according to 16 wherein the second fluorescent layer is formed by photolithography and the first fluorescent layer is formed by printing, or printing and grinding.

According to the color conversion substrate of the invention, a multicolor emitting apparatus with excellent white balance and durability can be obtained.
According to the color conversion substrate of the invention, a white emitting apparatus with high efficiency and uniform emission can be obtained.

### Brief Description of Drawings

FIG. 1 is a schematic sectional view showing a color conversion substrate of the invention.
FIG. 2 is a schematic sectional view showing a color conversion substrate according to Embodiment 1 of the invention.
FIG. 3 is a schematic sectional view showing a color conversion substrate according to Embodiment 2 of the invention.
FIG. 4 is a schematic sectional view showing a color conversion substrate according to Embodiment 3 of the invention.
FIG. 5 is a schematic sectional view showing a color conversion substrate according to Embodiment 4 of the invention.
FIG. 6 is a schematic sectional view showing an emitting apparatus according to Embodiment 1 of the invention.
FIG. 7 is a schematic sectional view showing an emitting apparatus according to Embodiment 2 of the invention.
FIG. 8 is a schematic sectional view showing an emitting apparatus according to Embodiment 3 of the invention.
FIG. 9 is a schematic sectional view showing an emitting apparatus according to Embodiment 4 of the invention.
FIG. 10 is a schematic sectional view showing an emitting apparatus according to Embodiment 5 of the invention.
FIG. 11 is a schematic sectional view showing an emitting apparatus according to another embodiment of the invention.
FIG. 12 is a schematic sectional view showing a production method of a color conversion substrate according to one embodiment of the invention.
FIG. 13 is a schematic sectional view showing a production method of a color conversion substrate according to another embodiment of the invention.
FIG. 14 is a view showing steps of forming a polysilicon TFT.
FIG. 15 is a circuit diagram showing an electric switch connection structure including a polysilicon TFT.
FIG. 16 is a planar perspective view showing an electric switch connection structure including a polysilicon TFT.
FIG. 17 is a view showing examples of absorption and emission spectra of fluorescent materials, and (a) is a view showing an example of an organic fluorescent material and (b) is a view showing an example of a semiconductor nanocrystal.
FIG. 18 is an example of absorption spectra of semiconductor nanocrystals.

### Best Modes for Working the Invention

The color conversion substrate according to the invention is described below with reference to the drawings.

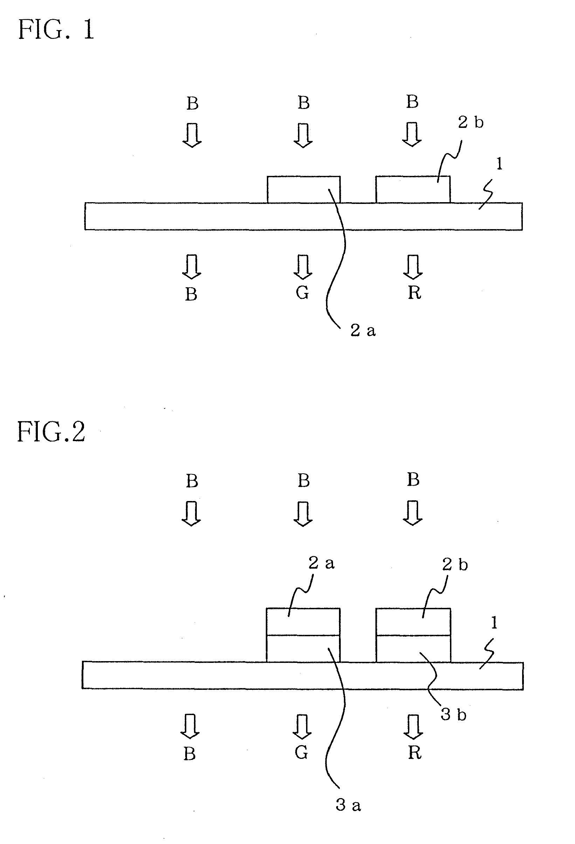

FIG. 1 is a schematic cross-sectional view of the color conversion substrate according to the invention.
The color conversion substrate includes a supporting substrate 1, a green fluorescent layer 2a which is a first fluorescent layer, and a red fluorescent layer 2b which is a second fluorescent layer, the green fluorescent layer 2a and the red fluorescent layer 2b being provided on the supporting substrate 1. In FIG. 1, one green fluorescent layer 2a and one red fluorescent layer 2b are illustrated. Note that the green fluorescent layers 2a and the red fluorescent layers 2b are repeatedly formed in a pattern. This also applies to other drawings.
The green fluorescent layer 2a is a layer including an organic fluorescent material, which absorbs light emitted from an emitting device and emits fluorescence (first fluorescence) having a wavelength differing from that of the light emitted from the emitting device.
The red fluorescent layer 2b is a layer including a semiconductor nanocrystal, which absorbs light emitted from the emitting device and emits fluorescence (second fluorescence) having a wavelength differing from that of the light emitted from the emitting device.

For example, when using a blue emitting device as the emitting device (excitation light source: light is indicated by arrows in the drawings; B indicates blue, G indicates green, and R indicates red), the green fluorescent layer 2a absorbs light in the blue region and emits green fluorescence. Likewise, the red fluorescent layer 2b absorbs light in the blue region and emits red fluorescence.

According to the invention, since the green fluorescent layer 2a and the red fluorescent layer 2b are formed using different fluorescent materials, an emitting apparatus which exhibits an excellent white balance, excellent visibility, and high durability can be obtained without adjusting the emission color of the emitting device.
Specifically, since the green fluorescent layer 2a may have a small Stokes shift, the green fluorescent layer 2a can be formed of a layer including an organic fluorescent material. Therefore, the green fluorescent layer 2a can sufficiently absorb the light emitted from the emitting device having an emission peak in the blue region and efficiently convert the absorbed light into green light with excellent chromatic purity. Accordingly, the white balance of the emitting apparatus is ensured by eliminating the problem relating to the weak green emission.

On the other hand, occurrence of concentration quenching can be prevented in the red fluorescent layer 2b by using a layer including a semiconductor nanocrystal having a large difference between the high-absorption wavelength region and the fluorescence peak wavelength. Therefore, the red fluorescent layer 2b can sufficiently absorb the light emitted from the emitting device having an emission peak in the blue region and efficiently convert the absorbed light into red light with excellent chromatic purity. As a result, the emitting apparatus exhibits an excellent white balance, whereby nonuniform deterioration or image burn of the emitting apparatus can be suppressed.

Since the blue light is emitted as display light in the region in which the fluorescent layers 2a and 2b are not formed, the three primary colors can be displayed, whereby a full color display can be achieved.

When using a white emitting device ("blue + orange to red" or "blue green + orange to red") as the emitting device, a strong red emission can be suppressed in comparison with the case of using a color conversion substrate using organic fluorescent materials for both the green fluorescent layer 2a and the red fluorescent layer 2b. Therefore, the white balance of the emitting apparatus is ensured, whereby nonuniform deterioration or image burn of the emitting apparatus can be suppressed.

In the invention, the first fluorescent layer includes the organic fluorescent material, and the second fluorescent layer includes the semiconductor nanocrystal. This means that the absorption (absorbance) of the organic fluorescent material or the semiconductor nanocrystal accounts for 50% or more, and preferably 70% or more of the absorption (absorbance) of the first fluorescent layer or the second fluorescent layer at the emission peak wavelength of the emitting device. Specifically, the organic fluorescent material mainly absorbs the light emitted from the emitting device and emits fluorescence in the first fluorescent layer, and the semiconductor nanocrystal mainly absorb the light emitted from the emitting device and emit fluorescence in the second fluorescent layer.

Therefore, the first fluorescent layer may include a small amount of inorganic fluorescent material such as semiconductor nanocrystal, and the second fluorescent layer may include a small amount of organic fluorescent material, if necessary. This allows insufficient durability of the first fluorescent layer to be reinforced by the inorganic fluorescent material, or allows fluorescence from the second fluorescent layer to be increased by allowing the organic fluorescent material to absorb light escaping from the second fluorescent layer.

In the invention, it is preferable that the first fluorescent layer be a green fluorescent layer and the second fluorescent layer be a red fluorescent layer. This allows provision of a color conversion substrate suitable for a full color emitting apparatus which exhibits excellent conversion efficiency and color reproducibility.
Moreover, since the thickness of the first fluorescent layer (green fluorescent layer) can be reduced, the thickness of the first fluorescent layer can be made equal to the thickness of the red fluorescent layer. This allows the surface of the color conversion substrate to be easily made flat, whereby defects of the emitting device due to a short circuit, breakage, or the like can be reduced when stacking the emitting device.
In addition, since the distance between each fluorescent layer and the emitting device can be made uniform when forming an emitting apparatus by combining the color conversion substrate with the emitting device, the visibility (e.g. viewing angle characteristics) of the emitting apparatus can be improved.
Preferred embodiments of the color conversion substrate and the emitting apparatus according to the invention are described below with reference to the drawings.

### <Color conversion substrate>

### First embodiment

FIG. 2 is a schematic cross-sectional view showing a first embodiment of the color conversion substrate according to the invention.
In this color conversion substrate, a color filter 3a and a color filter 3b are formed on the supporting substrate 1, and the first fluorescent layer 2a and the second fluorescent layer 2b are respectively formed on the color filter 3a and the color filter 3b.
Since the color of light emitted from each fluorescent layer can be adjusted by the color filter stacked on each fluorescent layer, the color reproducibility of an emitting apparatus with the substrate can be improved. Moreover, since excitation of the fluorescent layer due to external light can be suppressed by the color filter, an emitting apparatus exhibiting higher contrast can be obtained.

For example, a full color emitting apparatus exhibiting excellent chromatic purity and high contrast can be formed by using a blue emitting device as the emitting device, a green fluorescent layer as the first fluorescent layer 2a, a color filter which selectively allows green light to pass through as the color filter 3a, a red fluorescent layer as the second fluorescent layer 2b, and a color filter which selectively allows red light to pass through as the color filter 3b.

The color filter preferably has a transparency of 10% or less, and still more preferably 1% or less at the major peak wavelength in an excitation spectrum where the maximum fluorescence intensity is obtained from each fluorescent layer. The color filter preferably has a transparency of 70% or more, and still more preferably 80% or more at the wavelength of the emission peak from the fluorescent layer (including light escaping from the emitting device).

### Second embodiment

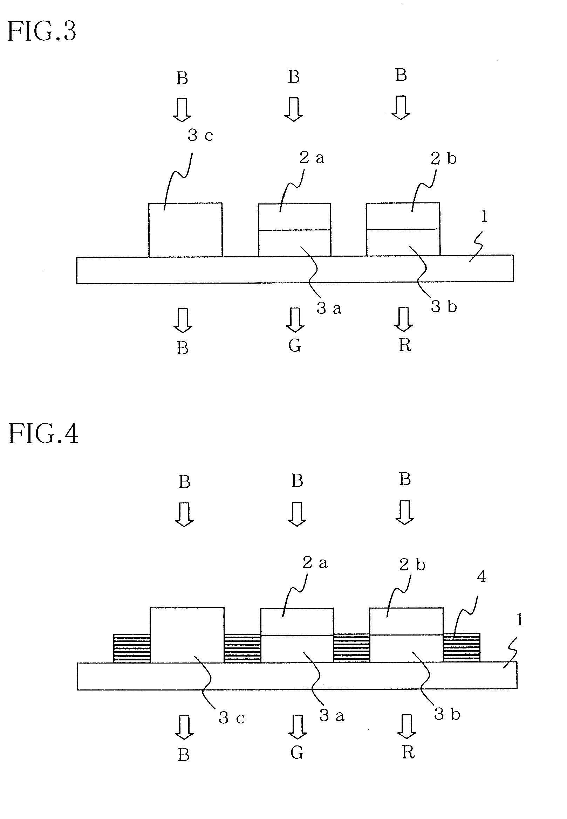

FIG. 3 is a schematic cross-sectional view showing a second embodiment of the color conversion substrate according to the invention.
In this color conversion substrate, a blue color filter 3c is formed on the side of the first fluorescent layer 2a and the color filter 3a in the substrate according to the first embodiment.
This allows adjustment of the color of light emitted from the emitting device, whereby an emitting apparatus which emits blue light with higher chromatic purity can be obtained. Moreover, since incidence and reflection of external light into the emitting device can be suppressed, an emitting apparatus exhibiting higher contrast can be obtained.
In FIG. 3, the blue color filter 3c is formed on the end of the supporting substrate 1. Note that the blue color filter 3c is actually formed between the first fluorescent layer 2a and the second fluorescent layer 2b on the supporting substrate 1, since a plurality of blue color filters 3c are formed in a pattern.

The surface of the color conversion substrate can be made flat by adjusting the thickness of the color filter 3c almost equal to the thickness of the stacked first fluorescent layer 2a and the color filter 3a, and the thickness of the stacked second fluorescent layer 2b and the color filter 3b, whereby defects of the emitting device due to short circuit, breakage, or the like can be reduced. Moreover, since the distance between each layer on the color conversion substrate and the emitting device can be equalized, the visibility (e.g. viewing angle characteristics) of the emitting apparatus can be improved.

### Third embodiment

FIG. 4 is a schematic cross-sectional view showing a third embodiment of the color conversion substrate according to the invention.
In this color conversion substrate, black matrixes 4 are formed between the first fluorescent layer 2a and the second fluorescent layer 2b and between the first fluorescent layer 2a and the color filter 3c in the substrate of the second embodiment. This further improves the surface flatness of the color conversion substrate and the visibility (e.g. contrast and viewing angle characteristics) of an emitting apparatus with the substrate.

### Fourth embodiment

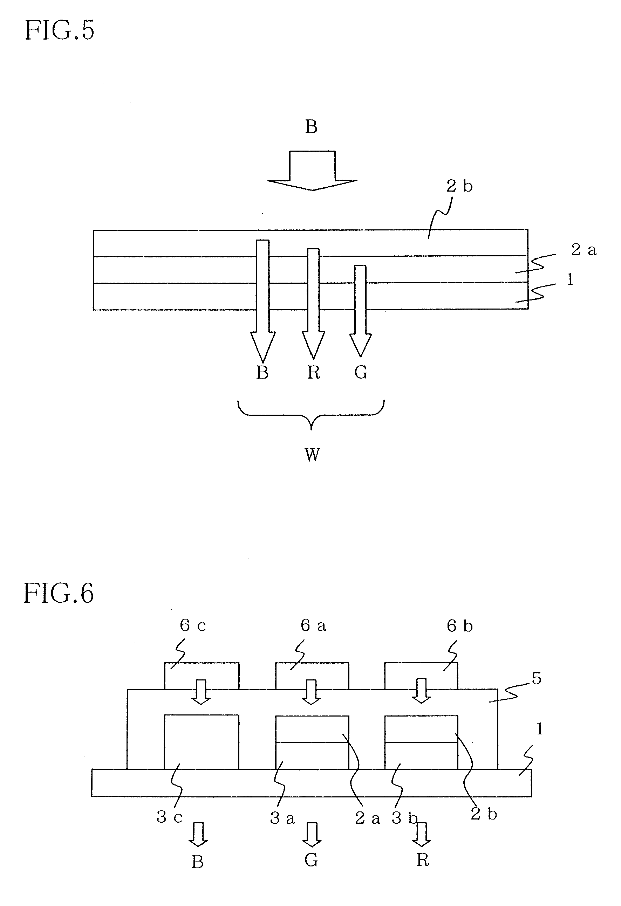

FIG. 5 is a schematic cross-sectional view showing a fourth embodiment of the color conversion substrate according to the invention.
In this color conversion substrate, the green fluorescent layer 2a (first fluorescent layer) and the red fluorescent layer 2b (second fluorescent layer) are stacked on the supporting substrate 1.
The green fluorescent layer 2a is a layer including an organic fluorescent material, which absorbs light emitted from an emitting device and emits fluorescence (first fluorescence) having a wavelength differing from that of the light emitted from the emitting device.
The red fluorescent layer 2b is a layer including a semiconductor nanocrystal, which absorbs light emitted from the emitting device and emits fluorescence (second fluorescence) having a wavelength differing from that of the light emitted from the emitting device.
Note that each fluorescent layer of the color conversion substrate allows part of the light emitted from the emitting device to pass through.
For example, when using a blue emitting device as the emitting device (excitation light source: light is indicated by arrows in the drawings; B indicates blue, G indicates green, and R indicates red), the green fluorescent layer 2a absorbs light in the blue region and emits green fluorescence. Likewise, the red fluorescent layer 2b absorbs light in the blue region and emits red fluorescence. Therefore, white light in which blue, green, and red light is mixed is outcoupled.
In the fourth embodiment, since the fluorescent layer does not include scattering particles (inorganic fluorescent material: Y(Gd)AG:Ce, i.e., (material obtained by doping metal oxide, sulfide, or the like with transition metal ion)), and the semiconductor nanocrystal is highly transparent, the scattering loss of light emitted from the emitting device and fluorescence is small, whereby an efficient white emitting apparatus can be obtained. Moreover, since the semiconductor nanocrystal exhibits high optical absorption efficiency, the thickness of the fluorescent layer need not be increased. This improves thickness uniformity, whereby emission nonuniformity is reduced.

A white emitting apparatus can also be obtained by using the color conversion substrate having any of the configurations shown in FIGS. 1 to 4. In particular, the configuration shown in FIG. 1 increases the luminous efficiency of the white emitting apparatus, since light emitted from the emitting device or the fluorescent layer can be outcoupled without being blocked by the color filter. Moreover, since the white emitting apparatus may have a broad white emission spectrum, the blue, green, and red emission spectra need not necessarily be sharpened using a color filter.
In the above-described color conversion substrates, the light outcoupling efficiency or the inplane emission uniformity can be improved by disposing a light diffusion layer or a luminance improving film on the outermost side in the light-outcoupling direction.

### <Emitting apparatus>

### First embodiment

FIG. 6 is a schematic cross-sectional view showing a first embodiment of the emitting apparatus according to the invention.
This embodiment relates to a multicolor emitting apparatus in which a protective layer 5 is formed on the color conversion substrate according to the above-described second embodiment, and emitting devices 6a, 6b, and 6c are stacked at positions corresponding to the first fluorescent layer, the second fluorescent layer, and the blue color filter, respectively.
This emitting apparatus is a bottom emission type emitting apparatus in which the emitting devices are stacked on the color conversion substrate and light is outcoupled from the apparatus through the supporting substrate. This configuration facilitates alignment of the emitting devices (6a, 6b, 6c) and the color conversion substrate. Moreover, since only one substrate is necessary, the thickness and the weight of the emitting apparatus can be reduced.

### Second embodiment

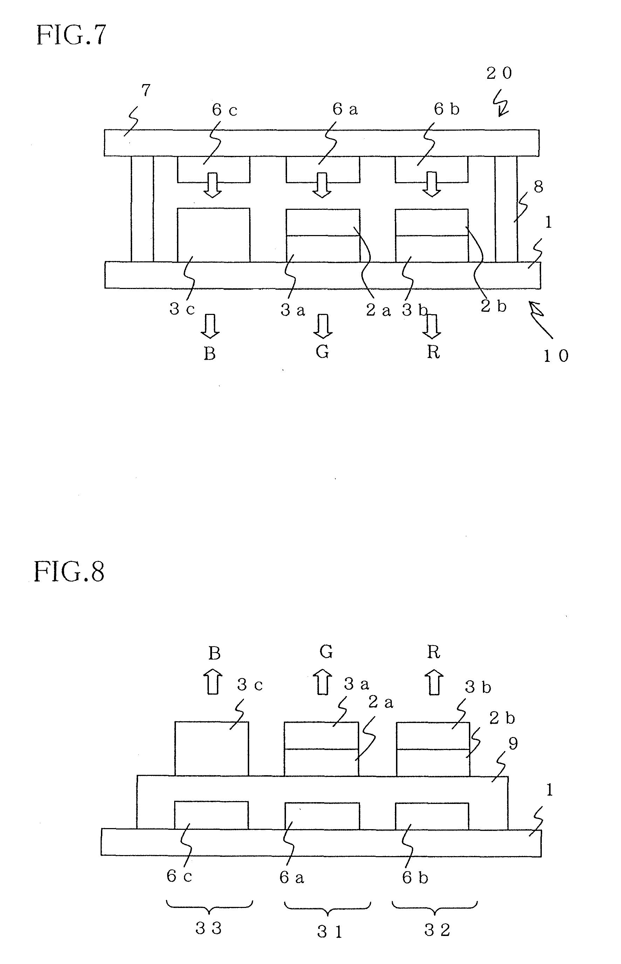

FIG. 7 is a schematic cross-sectional view showing a second embodiment of the emitting apparatus according to the invention.
This embodiment relates to a multicolor emitting apparatus in which the color conversion substrate 10 according to the above-described second embodiment and an emitting device substrate 20 in which the emitting devices (6a, 6b, 6c) are formed on a substrate 7 are bonded through an adhesive layer 8 so that the substrate 20 faces the substrate 10.
This emitting apparatus is a top emission type emitting apparatus in which the emitting devices face the color conversion substrate and light is outcoupled from the apparatus not through the substrate 7 on which the emitting devices are formed. According to this embodiment, since the color conversion substrate is separated from the emitting devices, adverse effects (e.g. unevenness of the substrate or movement of water from the fluorescent layers to the emitting devices) on the emitting devices due to the color conversion substrate can be reduced in comparison with a bottom emission type emitting apparatus.

### Third embodiment

FIG. 8 is a schematic cross-sectional view showing a third embodiment of the emitting apparatus according to the invention.
This embodiment relates to a multicolor emitting apparatus in which the first emitting device 6a, the second emitting device 6b, and the third emitting device 6c are formed on the supporting substrate 1, and which includes first, second and third pixels 31, 32 and 33 on a passivation layer 9. In the first pixel 31, the first emitting device 6a, the first fluorescent layer 2a, and the color filter 3a are stacked in this order. In the second pixel 32, the second emitting device 6b, the first fluorescent layer 2b, and the color filter 3b are stacked in this order. In the third pixel 33, the third emitting device 6c and the color filter 3c are stacked.
According to the third embodiment, since the light emitted from the emitting device can be efficiently introduced into the fluorescent layer by directly disposing the fluorescent layer above the emitting device, the efficiency of the emitting apparatus can be improved.

In each of the above-described embodiments illustrating a full color emitting apparatus, the third pixel is formed using the blue color filter layer. Note that the invention also includes an emitting apparatus in which the third pixel is not formed. A black matrix may be disposed between the pixels.

### Fourth embodiment

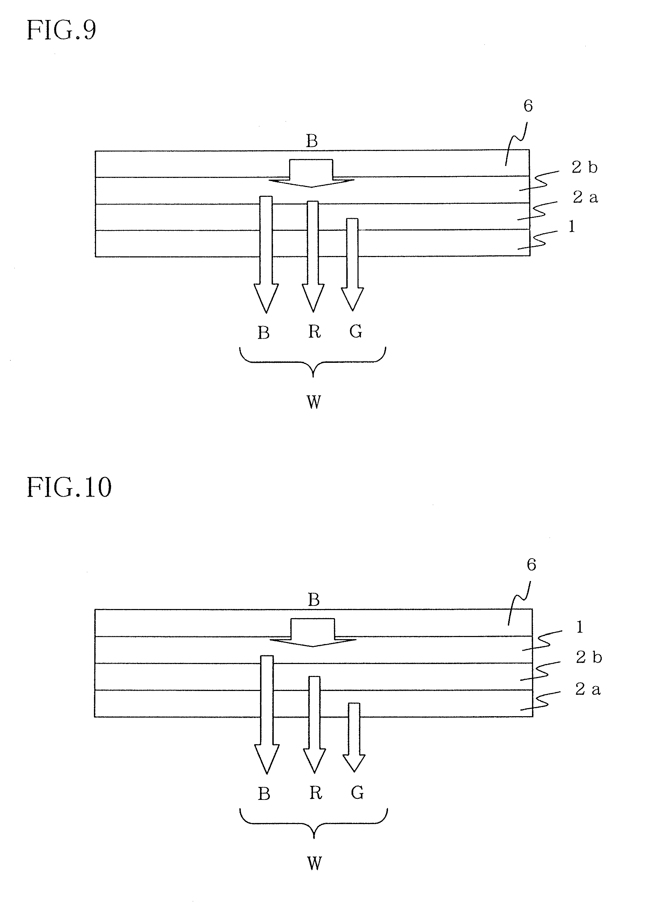

FIG. 9 is a schematic cross-sectional view showing a fourth embodiment of the emitting apparatus according to the invention.
This embodiment relates to a white emitting apparatus in which the emitting device 6 is stacked on the fluorescent layer 2b of the color conversion substrate according to the above-described fourth embodiment. A protective layer or a passivation layer may be disposed between the fluorescent layer and the emitting device, if necessary.
According to the configuration of this emitting apparatus, since the emitting device 6 is disposed near the fluorescent layer, the light emitted from the emitting device 6 can be efficiently introduced into the fluorescent layers 2a and 2b, whereby the luminous efficiency of the emitting apparatus can be improved.

### Fifth embodiment

FIG. 10 is a schematic cross-sectional view showing a fifth embodiment of the emitting apparatus according to the invention.
This embodiment relates to a white emitting apparatus in which the emitting device 6 is stacked on the color conversion substrate according to the above-described fourth embodiment on the side opposite to the fluorescent layers 2a and 2b.
According to the configuration of this emitting apparatus, since the emitting device 6 can be separated from the fluorescent layers 2a and 2b by the supporting substrate, effects on the emitting device 6 due to water, oxygen, or monomer released from the fluorescent layers 2a and 2b and the surface unevenness of the fluorescent layers 2a and 2b can be reduced. Moreover, the configuration can be simplified.
The emitting device substrate may be disposed to face the color conversion substrate, or the fluorescent layer may be disposed above the emitting device, as described in the second or third embodiment.
In the above-described emitting apparatus, the color conversion substrates shown in FIGS. 1 to 4 may be used instead of the color conversion substrate according to the fourth or fifth embodiment. In particular, the color conversion substrate shown in FIG. 1 is preferably used. This is because the light emitted from the emitting device or the fluorescent layer can be outcoupled without being blocked by the color filter, whereby the luminous efficiency of the white emitting apparatus can be increased.

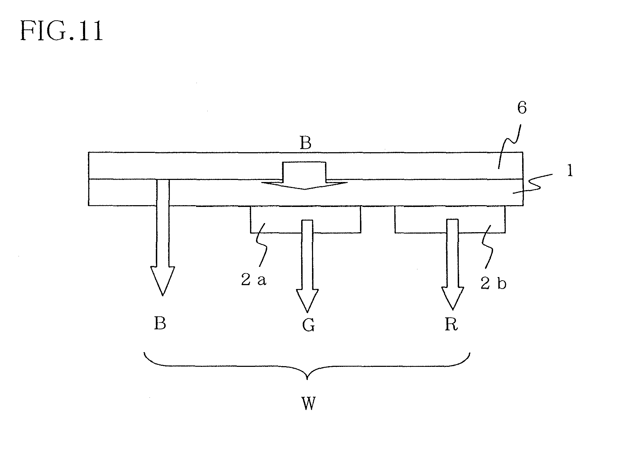

Since the white emitting apparatus may have a broad white emission spectrum, the blue, green, and red emission spectra need not necessarily be sharpened using the color filter. FIG. 11 shows an example of such a white emitting apparatus.
FIG. 11 is a schematic cross-sectional view showing another embodiment of the emitting apparatus according to the invention.
This embodiment relates to a white emitting apparatus in which the emitting device 6 is stacked on the color conversion substrate according to the above-described first embodiment on the side opposite to the fluorescent layers 2a and 2b.

In the above-described white emitting apparatus, the emitting device may be separated in the shape of islands or pixels so that defects do not affect the entire display.
The light outcoupling efficiency or the inplane emission uniformity can be improved by disposing a light diffusion layer or a luminance improving film on the outermost side in the light-outcoupling direction.
Each member of the color conversion substrate and the emitting apparatus according to the invention is described below.

### 1. Supporting substrate

It is a substrate for supporting the color conversion substrate or the emitting apparatus, and is preferably a flat and smooth substrate having a transmittance of 50% or more to light within visible ranges of 400 to 700 nm. Specific examples thereof include a glass plate and a polymer plate.
Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.
The same substrates can be used for a substrate to support the emitting device. When the substrate does not transmit light to be outcoupled, it does not need to be transparent.

### 2. First fluorescent layer

The first fluorescent layer is a layer including an organic fluorescent material. The first fluorescent layer generally has a configuration in which the organic fluorescent material is dispersed in a transparent medium. In particular, it is preferable that the organic fluorescent material be molecularly dispersed. When the organic fluorescent material is molecularly dispersed, the transparency is increased due to a decrease in light scattering in the fluorescent layer, whereby an emitting apparatus exhibiting excellent visibility and high contrast without color smearing can be obtained.
The statement "molecularly dispersed" means that the maximum particle size of the organic fluorescent material observed using a scanning electron microscope (SEM) or a transmission electron microscope (TEM) is 10 nm or less, and preferably 1 nm or less, that is, almost no organic fluorescent materials are observed. When the organic fluorescent material is molecularly dispersed, the light emitted from the emitting device is efficiently absorbed even if the amount of the organic fluorescent material added to the fluorescent layer is small, whereby the thickness of the fluorescent layer can be reduced. Moreover, since the effects of the organic fluorescent material are reduced even if the thickness of the fluorescent layer is increased, the fluorescent layer can be easily processed.

The organic fluorescent material includes stylbene dyes such as 1,4-bis(2-methylstyryl)benzene (Bis-MSB) and trans-4,4'-diphenylstylbene (DPS); coumarin dyes such as 7-hydroxy-4-methylcoumarin (coumarin 4), 2,3,5,6-1H,4H-tetrahydro-8-trifluoromethylquinolidino(9,9a,1-gh)coumarin (coumarin 153), 3-(2'-benzothiazolyl)-7-diethylaminocoumarin (coumarin 6) and 3-(2'-benzimidazolyl)-7-N,N-diethylaminocoumarin (coumarin 7); a coumarin type dyes such as Basic Yellow 51; naphthalimide dyes such as Solvent Yellow 11 and Solvent Yellow 116; and perylene dyes.

Also, cyanine dyes such as 4-dicyanomethylene-2-methyl-6-(p-dimethylaminostyryl)-4H-pyran (DCM); pyridine dyes such as 1-ethyl-2-(4-(p-dimethylaminophenyl)-1,3-butadienyl)-pyridinium-perchlorate (pyridine 1); rhodamine dyes such as Rhodamine B and Rhodamine 6G; and oxadine dyes can be used.
Various dyes (direct dyes, acidic dyes, basic dyes, disperse dyes and so on) can be selected if they have fluorescent properties.

The fluorescent dye that has been beforehand kneaded into a pigment resin may be used. Such pigment resins include polymethacrylic acid esters, polyvinyl chlorides, vinyl chloride vinyl acetate copolymers, alkyd resins, aromatic sulfonamide resins, urea resins, melamine resins and benzoguanamine resins.
These fluorescent dyes or pigments may be used individually or in mixtures if necessary.

In the invention, it is preferable that the organic fluorescent material of the first fluorescent layer include the perylene dye. The perylene dye exhibits excellent fluorescence properties and light durability and does not contain a highly reactive unsaturated bond in its molecule. Therefore, since the perylene dye is only slightly affected by the environment such as a binder resin, nonuniform deterioration (image burn) of the emitting apparatus using the color conversion substrate can be suppressed. As a result, a fluorescent layer exhibiting high conversion efficiency and excellent durability can be obtained.
As specific examples of the perylene dye, compounds shown by the following formulas (1) to (3) can be given.

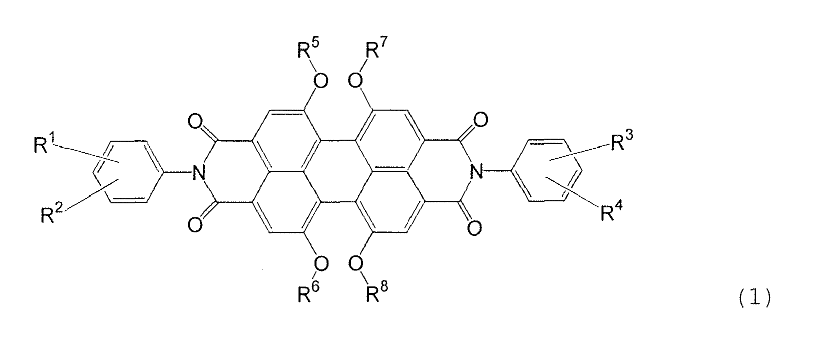

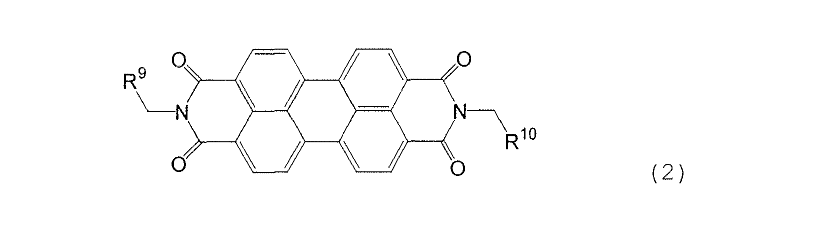

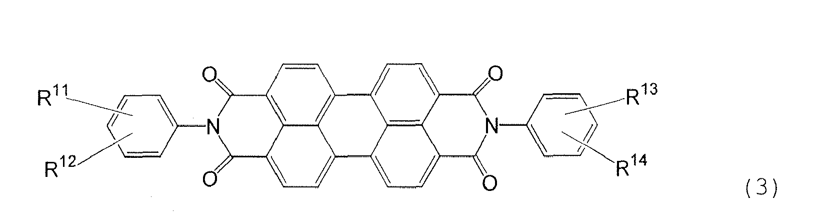

wherein R¹ to R⁴ individually represent hydrogen, a linear alkyl group, a branched alkyl group, or a cycloalkyl group, which may be substituted; R⁵ to R⁸ individually represent a phenyl group, a heteroaromatic group, a linear alkyl group, or a branched alkyl group, which may be substituted; R⁹ and R¹⁰ individually represent hydrogen, a linear alkyl group, a branched alkyl group, or a cycloalkyl group, which may be substituted; and R¹¹ to R¹⁴ individually represent hydrogen, a linear alkyl group, a branched alkyl group, or a cycloalkyl group, which may be substituted.

### Transparent medium

A transparent medium is a medium in which an organic fluorescent material is dispersed and retained, and can be selected from transparent materials such as glasses and transparent resins.
Specific examples include transparent resins (polymers) such as polymethyl methacrylate, polyacrylate, polycarbonate, polyvinyl alcohol, polyvinyl pyrrolidone, hydroxyethylcellulose, and carboxymethylcellulose.

A photosensitive resin for photolithography may also be selected in order to separately arrange a fluorescent layer in a plane.
Examples are photo-setting resist materials having reactive vinyl groups such as acrylic acid type, methacrylic acid type, polyvinyl cinnamate type and cyclic rubber type. In the case where a printing method is used, a printing ink (medium) using a transparent resin may be selected. Monomers, oligomers and polymers of polyvinyl chloride resins, melamine resins, phenol resins, alkyd resins, epoxy resins, polyurethane resins, polyester resins, maleic acid resins and polyamide resins can be exemplified.
They may be thermosetting resins.
These resins may be used individually or in mixtures.

In the color conversion substrate according to the invention, it is preferable that the first fluorescent layer include the organic fluorescent material which is dispersed in a transparent medium which does not have an ethylenic unsaturated bond.
When dispersing the organic fluorescent material in a transparent medium (binder resin) having an ethylenic unsaturated bond, the organic fluorescent material may react with the ethylenic unsaturated bond, or the organic fluorescent material may deteriorate due to radicals produced with time.
Therefore, the durability of the fluorescent layer can be improved by dispersing the organic fluorescent material in a transparent medium (binder resin) which does not have an ethylenic unsaturated bond, whereby nonuniform deterioration (image burn) of the emitting apparatus using the color conversion substrate can be prevented.

The term "transparent medium which does not have an ethylenic unsaturated bond" used herein means a transparent medium which does not originally have an ethylenic unsaturated bond, or a transparent medium which has an ethylenic unsaturated bond before curing and of which the ethylenic unsaturated bond is not observed after formation of the fluorescent layer (after curing). Note that the "transparent medium which does not have an ethylenic unsaturated bond" is preferably a transparent medium which does not originally have an ethylenic unsaturated bond, since it is difficult to completely eliminate the ethylenic unsaturated bond during the formation process of the fluorescent layer.
The presence or absence of an ethylenic unsaturated bond may be confirmed by subjecting the fluorescent layer or the transparent medium to infrared red (IR) analysis and determining the presence or absence of the absorption peak specific to the ethylenic unsaturated bond.

When using a resin which does not have an ethylenic unsaturated bond as the transparent medium, it is preferable that the organic fluorescent material be a coumarin dye. The coumarin dye exhibits extremely high fluorescence properties, and contains a highly reactive unsaturated bond in its molecule. Therefore, when dispersing the coumarin dye in a transparent medium (binder resin) having an ethylenic unsaturated bond, the coumarin dye may react with the transparent medium upon irradiation to easily lose the absorption/fluorescence properties.

Therefore, a fluorescent layer exhibiting excellent efficiency and durability can be obtained by dispersing the coumarin dye in a transparent medium which does not have an ethylenic unsaturated bond. This suppresses nonuniform deterioration (image burn) of the emitting apparatus using the color conversion substrate.

Note that it is unnecessary to select a resin when using the perylene dye, since the perylene dye does not contain a highly reactive unsaturated bond in its molecule.

The first fluorescent layer can be formed by using a liquid dispersion prepared by mixing and dispersing the organic fluorescent material and the transparent medium using a known method such as milling or ultrasonic dispersion.
In this case, a good solvent for the transparent medium may be used. A pattern or a continuous film of the fluorescent layer may be formed by photolithography or printing using the resulting liquid dispersion.

The mixing ratio of the organic fluorescent material to the transparent medium (organic fluorescent material/transparent medium: weight ratio) is preferably 1/100000 to 1/20, and still more preferably 1/10000 to 1/30, although the mixing ratio varies depending on the type of organic fluorescent material and the type of emitting apparatus. If the mixing ratio is less than 1/100000, the organic fluorescent material may not sufficiently absorb the light emitted from the emitting device, whereby the conversion capability may be decreased or the chromaticity after conversion may deteriorate. If the thickness of the fluorescent layer is increased in order to allow the fluorescent layer to absorb the light emitted from the emitting device, the mechanical stability of the emitting apparatus may be decreased due to thermal stress or the like, or it may become difficult to make the color conversion substrate flat. This may result in improper distances between the emitting devices and the color conversion substrate, whereby the visibility (e.g. viewing angle characteristics) of the emitting apparatus may be adversely affected.
If the mixing ratio exceeds 1/20, the organic fluorescent material may be associated, whereby concentration quenching may occur.
Note that a UV absorber, dispersant, leveling agent, and the like may be added to the fluorescent layer insofar as the object of the invention is not impaired.

### 3. Second fluorescent layer

The second fluorescent layer is a layer including a semiconductor nanocrystal. The semiconductor nanocrystal are generally dispersed in a transparent medium.

As examples of the semiconductor nanocrystal, crystals formed of group IV element compounds (group of the periodic table (long period); hereinafter the same), group IIa element-group VIb element compounds, group IIIa element-group Vb element compounds and group IIIb element-group Vb element compounds, and chalcopyrite type compounds can be given.
Specific examples thereof include crystals of Si, Ge, MgS, ZnS, MgSe, ZnSe, AlP, GaP, AlAs, GaAs, CdS, CdSe, InP, InAs, GaSb, AlSb, ZnTe, CdTe, InSb, CuAlS₂, CuAlSe₂, CuAlTe₂, CuGaS₂, CuGaSe₂, CuGaTe₂, CuInS₂, CuInSe₂, CuInTe₂, AgAlS₂, AgAlSe₂, AgAlTe₂, AgGaS₂, AgGaSe₂, AgGaTe₂, AgInS₂, AgInSe₂, AgInTe₂, ZnSiP₂, ZnSiAs₂, ZnGeP₂, ZnGeAs₂, ZnSnP₂, ZnSnAs₂, ZnSnSb₂, CdSiP₂, CdSiAs₂, CdGeP₂, CdGeAs₂, CdSnP₂, CdSnAs₂, and mixed crystals of these elements or compounds.

Of these, AlP, GaP, Si, ZnSe, AlAs, GaAs, CdS, InP, ZnTe, AlSb, CdTe, CdSe, CuGaSe₂, CuGaTe₂, CuInS₂ and CuInSe₂ and CuInTe₂ are preferable. In particular, ZnSe, CdSe, GaAs, CdS, InP, ZnTe, CdTe, CuInS₂ and CuInSe₂ (direct transition semiconductors) are still more preferable from the viewpoint of high luminous efficiency or high light absorption efficiency of an excitation light source.
In order to obtain red fluorescence, the type and diameter of semiconductor nanocrystal are adjusted. When producing semiconductor nanocrystals, the adjustment can be easily carried out by measuring absorption and fluoresence.

The semiconductor nanocrystal can be produced using methods disclosed in United States Patent No. 6,501,091, JP-A-2003-286292, 2004-510678, 2004-315661 and the like.
As a production example, a precursor solution prepared by mixing trioctyl phosphine (TOP) with trioctyl phosphine selenide and dimethylcadmium is added to trioctyl phosphine oxide (TOPO) heated at 350°C.

As another example of the semiconductor nanocrystal used in the invention, core/shell semiconductor nanocrystal can be given. For example, the core/shell semiconductor nanocrystal has a structure in which the surface of a core particle formed of CdSe (band gap: 1.74 eV) is coated (covered) with a shell formed of a semiconductor material having a large band gap such as ZnS (band gap: 3.8 eV). This makes it easy to exhibit confinement effects on electrons produced in the core particle.
The core/shell semiconductor nanocrystals may be produced using the above known methods.
For example, a CdSe core/ZnS shell structure can be produced by adding a precursor solution prepared by mixing TOP with diethylzinc and trimethylsilyl sulfide to a TOPO solution heated at 140°C in which CdSe core particles are dispersed.

In the above specific examples of the semiconductor nanocrystal, a phenomenon tends to occur in which S, Se, or the like is removed by an active component (e.g. unreacted monomer or water) in the transparent medium (described later) to damage the crystal structure of the nanocrystal, whereby the fluorescent properties disappear. In order to prevent this phenomenon, the surface of the semiconductor nanocrystal may be modified with a metal oxide such as silica, an organic substance, or the like.
In order to improve dispersibility in the transparent medium, the surface of the particles may be modified or coated with a long-chain alkyl group, phosphoric acid, a resin, or the like.
The above semiconductor nanaocrystal may be used either individually or in combination of two or more.

Examples of the transparent medium are the same as those for the first fluorescent layer.

The second fluorescent layer is formed using a liquid dispersion prepared by mixing and dispersing the above semiconductor nanocrystal and the transparent medium using a known method such as milling or ultrasonic dispersion.
In this case, a good solvent for the transparent medium may be used. A fluorescent layer pattern can be formed with the use of this dispersion by photolithography or various printing methods.

The mixing ratio of the semiconductor nanocrystal to the transparent medium (semiconductor nanocrystal/transparent medium: weight ratio) is preferably 1/1000 to 4/6, and still more preferably 1/100 to 3/7, although the mixing ratio varies depending on the specific gravity and the particle size of the semiconductor nanocrystal.
If the mixing ratio is less than 1/1000, the semiconductor nanocrystal may not sufficiently absorb the light emitted from the emitting device, whereby the conversion capability may be decreased or the chromaticity after conversion may deteriorate. If the thickness of the fluorescent layer is increased in order to allow the fluorescent layer to absorb the light emitted from the emitting device, the mechanical stability of the emitting apparatus may be decreased due to thermal stress or the like, or it may become difficult to make the color conversion substrate flat. This may result in improper distances between the emitting devices and the color conversion substrate, whereby the visibility (e.g. viewing angle characteristics) of the emitting apparatus may be adversely affected.
If the mixing ratio exceeds 4/6, it may become difficult to stably disperse the semiconductor nanocrystal by controlling the particle size. Further the light outcoupling efficiency may be decreased due to an increase in the refractive index, or it may become difficult to form a pattern.
Note that a UV absorber, dispersant, leveling agent, and the like may be added to the fluorescent layer insofar as the object of the invention is not impaired.

### 4. Color filter

Examples of the color filter layer include only the following dyes or solid objects in which a dye is dissolved or dispersed in a binder resin.

### A. Dyes for red color filter

One or a mixture of at least two and more selected from Perylene pigments, lake pigments, azoic pigments, quinacridone pigments, anthraquinone pigments, anthracene pigments, isoindorine pigments, isoindorinone pigments, diketopyrrolopyrrole pigments and so on can be exemplified.

### B. Dyes for green color filter

One or a mixture of at least two and more selected from halogen-multisubstituted phthalocyanine pigments, halogen-multisubstituted copper phthalocyanine dyes, triphenylmethane basic dyes, isoindorine pigments, isoindorinone pigments and so on can be exemplified.

### C. Dyes for blue color filter

One or a mixture of at least two and more selected from copper phthalocyanine dyes, indanthrone pigments, indophenol pigments, cyanine pigments and dioxazin pigments and so on can be exemplified.

As the binder resin, a material similar to the material used for the first fluorescent layer may be selected. As the binder resin necessary for separately disposing the color filters in a plane, a material similar to the material used for the fluorescent layer may be selected. The color filter may be patterned in the same manner as the fluorescent layer irrespective of whether the color filter mainly includes a dye or includes a dye and a binder resin.
When the color filter includes a dye and a binder resin, the concentration of the dye is adjusted to such a range that the color filter can be patterned without causing a problem and the color filter allows the light emitted from the emitting device to sufficiently pass through. The dye is generally contained in the color filter including the binder resin in an amount of 5 to 50 wt%, although the amount varies depending on the type of dye.

### 5. Black matrix

The black matrix is used to prevent occurrence of a mixed color to improve the viewing angle characteristics of the emitting apparatus. The black matrix is generally disposed between the color fluorescent layers or the color filter patterns. As the material for the black matrix, a light-blocking material such as a black pigment or a metal is selected.

### 6. Protective film

The protective film is disposed on the fluorescent layer and used to make the surface of the color conversion substrate flat or prevent the color conversion substrate from being scratched from the outside.
As the material for the protective film, the material for the transparent medium can be given.

### 7. Passivation layer

The passivation layer is disposed to prevent deterioration of the emitting device (particularly an organic EL device) due to entrance of water, oxygen, and a low-molecular-weight organic component such as a monomer. The passivation layer is disposed between the color conversion substrate and the organic EL device to seal the organic EL device. As the material for the passivation layer, a film of an inorganic oxide, nitride, or oxynitride is selected.

### 8. Adhesive layer

The adhesive layer is disposed when bonding the color conversion substrate and the emitting device substrate. As the material for the adhesive layer, a two-component adhesive or a photocurable or heat-curable adhesive may be used. If necessary, glass beads, a desiccating agent, or the like may be dispersed in the adhesive layer for controlling the opening between the substrates or blocking water entering from the outside.

### 9. Emitting device

As the emitting device, an emitting device which emits visible light may be used. For example, an organic EL device, inorganic EL device, semiconductor light emitting diode, vacuum fluorescent tube, or the like may be used. Of these, an EL device using a transparent electrode on the light-outcoupling side, specifically, an organic EL device or an inorganic EL device including a reflecting electrode, an emitting layer, and a counter transparent electrode with the emitting layer placed therebetween is preferable. In particular, the organic EL device is preferred because a low-voltage high-luminance emitting device can be obtained by using the organic EL device, whereby a highly efficient emitting apparatus can be obtained.

In the emitting apparatus according to the invention, it is preferable that the emitting device be an emitting device having an emission peak in the blue region (i.e. 400 to 500 nm).
Since the blue chromaticity is improved by using the emitting device having an emission peak in the blue region, an emitting apparatus exhibiting excellent color reproducibility and a high color rendering index can be obtained. Therefore, the second fluorescent layer can be intensely excited, whereby the fluorescence intensity can be increased.

The color conversion substrate according to the invention may be produced using a known method. Examples of the method include printing and a method in which one of the fluorescent layers is formed on the above-described supporting substrate, the fluorescent layer is patterned by photolithography or the like, the other fluorescent layer is then formed, and the fluorescent layer is patterned to be positioned between the previously formed fluorescent layers.

In the method for producing the color conversion substrate according to the invention, the first fluorescent layer is formed after forming the second fluorescent layer. Since the second fluorescent layer including the semiconductor nanocrystal exhibits a heat resistance as high as 200°C or more and the first fluorescent layer including the organic fluorescent material exhibits low heat resistance, it is preferable to produce the color conversion substrate such that the thermal history of the first fluorescent layer is reduced.
This suppresses deterioration of the first fluorescent layer due to heat, whereby a first fluorescent layer exhibiting excellent efficiency and chromatic purity can be obtained. As a result, a color conversion substrate exhibiting high efficiency can be formed.

In the method for producing the color conversion substrate according to the invention, it is preferable to form the second fluorescent layer by photolithography, and to form the first fluorescent layer by printing or by forming a film by printing and grinding the resulting film. An example of the method for producing the color conversion substrate according to the invention is described below with reference to the drawings.

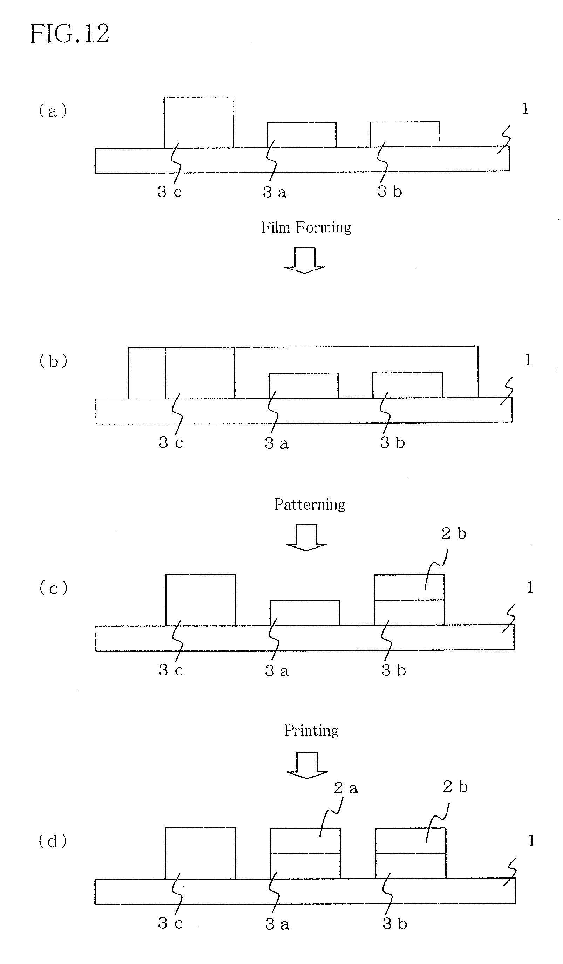

FIG. 12 is a view showing one embodiment of the method for producing the color conversion substrate according to the invention.
This embodiment uses a substrate in which the color filters (3a, 3b, 3c) are formed on the supporting substrate 1 using a known method (FIG. 12(a)).
A layer which serves as the second fluorescent layer is formed on the substrate 1 (FIG. 12(b)). The film may be formed using a known method such as spin coating or bar coating.
The layer is then patterned by photolithography to form the second fluorescent layer 2b on the second color filter 3b (FIG. 12(c)).
The first fluorescent layer 2a is formed on the first color filter 3a by printing to obtain a color conversion substrate (FIG. 12(d)).

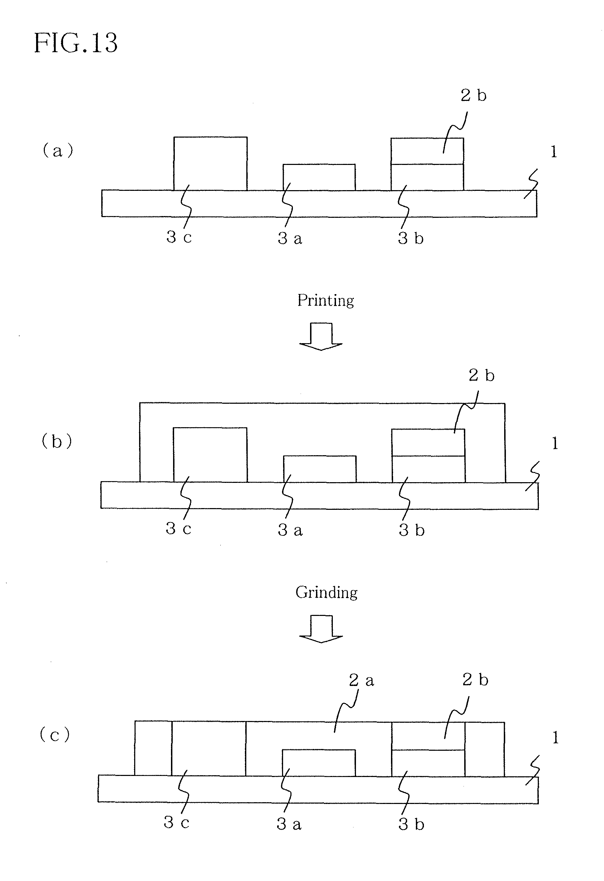

As shown in FIG. 13, a method may also be employed in which the second fluorescent layer 2b is formed on the second color filter 3b (FIG. 12(c) and FIG. 13(a)), a layer which serves as the first fluorescent layer is printed over the entire surface, not only on specified positions corresponding to color filters (FIG. 13(b)), and an unnecessary portion is removed by grinding to form the first fluorescent layer on the first color filter (FIG. 13(c)).
A first fluorescent layer exhibiting excellent chromatic purity and efficiency can be obtained by forming the first fluorescent layer in this manner.
Moreover, the thicknesses of the first fluorescent layer and the second fluorescent layer can be made uniform, whereby the flatness of the color conversion substrate can be improved. As a result, defects of the emitting apparatus can be reduced, and the visibility such as the viewing angle characteristics can be improved.

### EXAMPLES

The invention is described below in more detail by way of examples.

### Preparation Example 1

### <Preparation of red fluorescent material using a semiconductor nanocrystal: (CdSe)ZnS>

### (1) Preparation of a semiconductor nanocrystal: (CdSe)ZnS

0.5 g of cadmium acetate dihydrate and 1.6 g of tetradecylphosphonic acid (TDPA) were added to 5 ml of trioctylphosphine (TOP). The resulting solution was heated to 230°C and stirred for one hour in a nitrogen atmosphere. After cooling the solution to 60°C, 2 ml of a TOP solution containing 0.2 g of selenium was added to the solution to obtain a raw material solution.

10 g of trioctylphosphine oxide (TOPO) was placed in a three-necked flask and dried at 195°C for one hour under vacuum. After setting the pressure inside the flask at atmospheric pressure using nitrogen gas, the TOPO was heated to 270°C in a nitrogen atmosphere. 1.5 ml of the above raw material solution was added to the TOPO while stirring the system to effect a semiconductor nanocrystal core growth reaction. The reaction was allowed to proceed while confirming the fluorescence spectrum of the reaction solution. When the semiconductor nanocrystal exhibited a fluorescence peak at 615 nm when allowing the semiconductor nanocrystal to absorb light having a wavelength of 470 nm, the reaction solution was cooled to 60°C to terminate the reaction.
20 ml of butanol was added to the reaction solution to precipitate the semiconductor nanocrystal (core). The semiconductor nanocrystal was separated by centrifugation and dried under reduced pressure.

TOPO (5 g) was placed in a three-necked flask and dried at 195°C for one hour under vacuum. After setting the pressure inside the flask at atmospheric pressure using nitrogen gas, the TOPO was cooled to 60°C in a nitrogen atmosphere. Then, TOP (0.5 ml) and the semiconductor nanocrystal (core) (0.05 g) suspended in 0.5 ml of hexane were added to the TOPO. After stirring the mixture at 100°C for one hour under reduced pressure, the mixture was heated to 160°C. The pressure inside the flask was then set at atmospheric pressure using nitrogen gas to obtain a solution A.

A solution (solution B) separately prepared by dissolving 0.7 ml of a 1N n-hexane solution of diethyl zinc and 0.13 g of bis(trimethylsilyl) sulfide in 3 ml of TOP was added dropwise to the solution A maintained at 160°C in 30 minutes. The mixture was then cooled to 90°C and stirred for two hours. After cooling the mixture to 60°C, 20 ml of butanol was added to the mixture to precipitate semiconductor nanocrystal. The semiconductor nanocrystal was separated by centrifugation and dried under reduced pressure to recover the semiconductor nanocrystal (core: CdSe/shell: ZnS).

### (2) Preparation of red fluorescent material

The resulting semiconductor nanocrystal was dispersed in an acrylic negative-type photoresist (V259PA: manufactured by Nippon Steel Chemical Co., Ltd.) as a binder resin such that the concentration of the semiconductor nanocrystal in the solid content was 28 wt% (volume ratio: 7 vol%) to prepare a red fluorescent material using the semiconductor nanocrystal (CdSe)ZnS.
When subjecting the binder resin to IR measurement, absorption attributed to an unsaturated bond (C=C) was observed at 1410 cm⁻¹.

### Preparation Example 2

### <Preparation of green fluorescent material using a semiconductor nanocrystal: (CdSe)ZnS>

a Semiconductor nanocrystal (core: CdSe/shell: ZnS) were obtained in the same manner as in Preparation Example 1 except that the core growth reaction was allowed to proceed until the nanocrystal exhibited a fluorescence peak at 530 nm.
The resulting semiconductor nanocrystal was dispersed in the binder resin used in Preparation Example 2 such that the concentration of the semiconductor nanocrystal in the solid content was 28 wt% (volume ratio: 7 vol%) to prepare a green fluorescent material using the semiconductor nanocrystal (CdSe)ZnS.

### Preparation Example 3

### <Preparation of green fluorescent material 1 using organic fluorescent material (coumarin dye)>

Coumarin 6 in an amount of 0.7 wt% (concentration in solid content) was dissolved in a urethane thermosetting resin ("MIG2500" manufactured by Jujo Chemical Co., Ltd.) as a binder resin to prepare a green fluorescent material using the coumarin dye. When subjecting the binder resin to IR measurement, absorption attributed to an unsaturated bond (C=C) was not observed at 1410 cm⁻¹.

### Preparation Example 4

### <Preparation of green fluorescent material 2 using organic fluorescent material (coumarin dye)>

Coumarin 6 in an amount of 0.7 wt% (concentration in solid content) was dissolved in the binder resin used in Preparation Example 1 to prepare a green fluorescent material using the coumarin dye.

### Preparation Example 5

### <Preparation of green fluorescent material using organic fluorescent material (perylene dye)>

A perylene dye shown by the following formula (4)(R9 and R¹⁰ in the formula (2) are -CH(CH₃)₂) in an amount of 0.9 wt% (concentration in solid content) was dissolved in the binder resin used in Preparation Example 1 to prepare a green fluorescent material using the perylene dye.

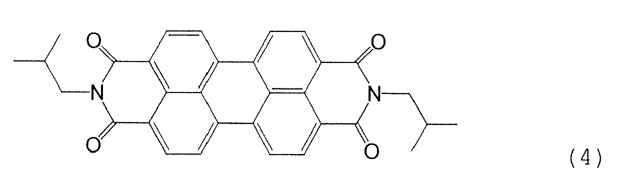

### Preparation Example 6

### <Preparation of red fluorescent material using organic fluorescent material (coumarin dye and rhodamine dye)>

Coumarin 6 in an amount of 0.7 wt% (concentration in solid content), rhodamine 6G in an amount of 0.3 wt% (concentration in solid content), and rhodamine B in an amount of 0.3 wt% (concentration in solid content) were dissolved in the binder resin used in Preparation Example 1 to prepare a red fluorescent material using the coumarin dye and the rhodamine dye.

### Example 1

### (1) Formation of color conversion substrate

V259BK (manufactured by Nippon Steel Chemical Co., Ltd.) as the material for a black matrix (BM) was applied by spin coating to a supporting substrate (transparent substrate) (OA2 glass manufactured by Nippon Electric Glass Co., Ltd.) having dimensions of 102×133×1.1 mm. Then, ultraviolet rays were applied through a photomask for forming a lattice-shaped pattern. The material was then developed using a 2% sodium carbonate aqueous solution and baked at 200°C to obtain a black matrix pattern (thickness: 1.5 µm).

V259G (manufactured by Nippon Steel Chemical Co., Ltd.) as the material for a green color filter was applied by spin coating. Then, ultraviolet rays were applied through a photomask aligned with the BM for forming 320 rectangular stripe patterns (90-µm line and 240-µm gap). The material was then developed using a 2% sodium carbonate aqueous solution and baked at 200°C to obtain a green color filter pattern (thickness: 1.5 µm).
V259R (manufactured by Nippon Steel Chemical Co., Ltd.) as the material for a red color filter was applied by spin coating. Then, ultraviolet rays were applied through a photomask aligned with the BM for forming 320 rectangular stripe patterns (90-µm line and 240-µm gap). The material was then developed using a 2% sodium carbonate aqueous solution and baked at 200°C to obtain a red color filter pattern (thickness: 1.5 µm) adjacent to the green color filter.
A dispersion of a copper phthalocyanine pigment, a dioxazine pigment and V259PA (manufactured by Nippon Steel Chemical Co., Ltd.) as the material for a blue color filter was applied by spin coating. Then, ultraviolet rays were applied through a photomask aligned with the BM for forming 320 rectangular stripe patterns (90-µm line and 240-µm gap). The material was then developed using a 2% sodium carbonate aqueous solution and baked at 200°C to obtain a blue color filter pattern (thickness: 13.5 µm) between the green color filter and the red color filter.

As the material for a red fluorescent layer, the material used in Production Example 1 was applied to the substrate by spin coating, and ultraviolet rays were applied in the area of the red color filter. The material was then developed using a 2% sodium carbonate aqueous solution and baked at 200°C to form a red fluorescent layer pattern (thickness: 12 µm) on the red color filter.
As the material for a green fluorescent layer, the material used in Production Example 3 was applied to the entire surface of the substrate by screen printing to form a film and baked at 180°C.
Further, the substrate was set on a tape grinder and the green fluorescent layer on the red fluorescent layer and the blue color filter was grinded to be removed with a WA6000 tape (manufactured by MIPOX). A green fluorescent layer pattern between the red fluorescent layer and blue color filter was formed. Differences in height among the color layers (red, green and blue) in the obtained color conversion substrate were 0.5 µm or less and their film thicknesses were around 12 µm, confirming that a color conversion substrate with excellent flatness was obtained.

### (2) Fabrication of emitting device (organic EL device) substrate

### (2-1) Formation of TFT substrate

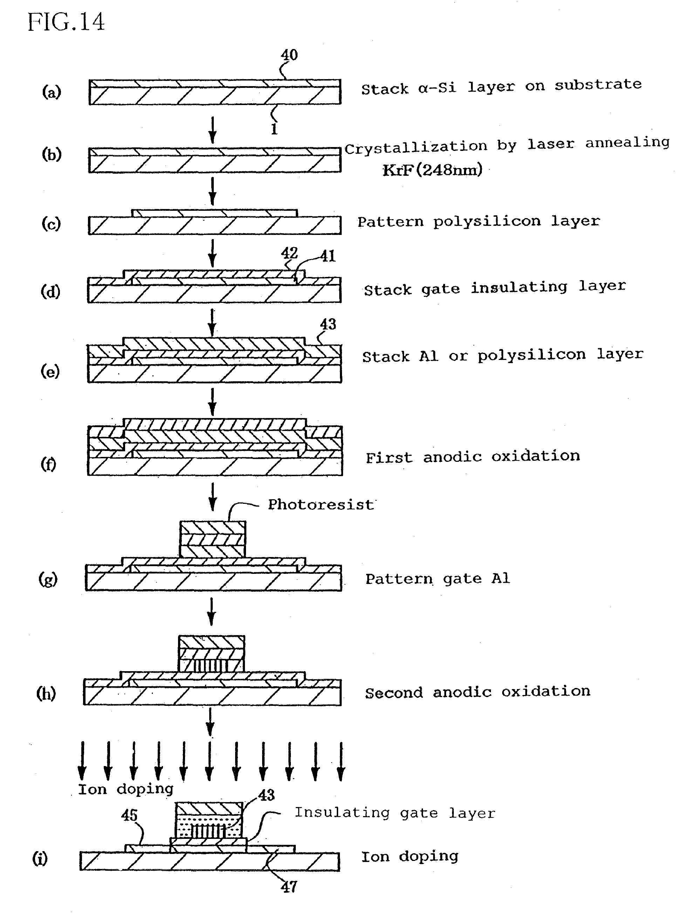

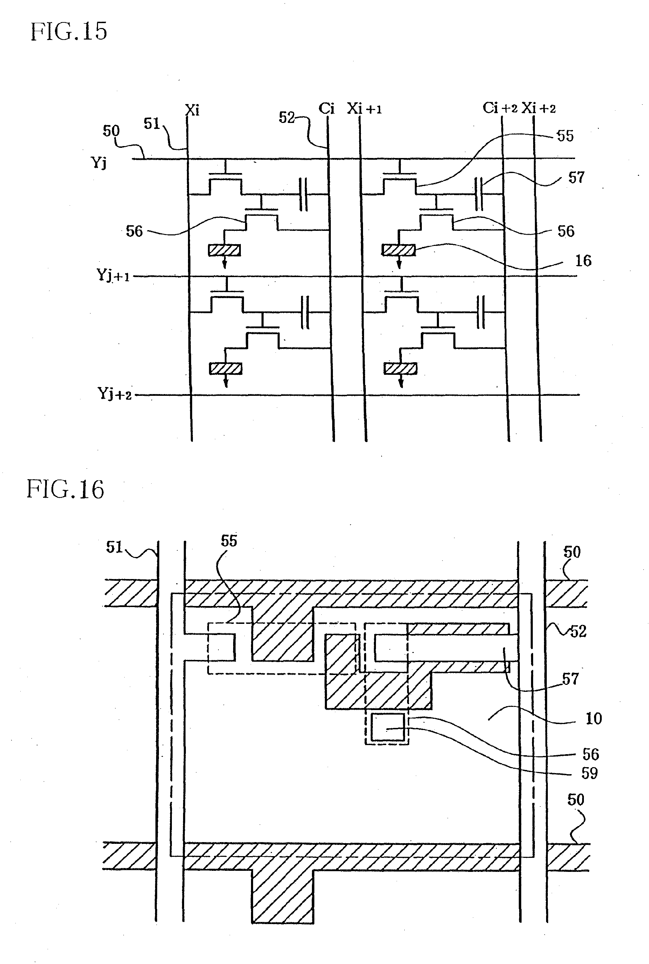

FIGS. 14(a) to (i) are views showing polysilicon TFT formation steps. FIG. 15 is a circuit diagram showing an electric switch connection structure including a polysilicon TFT, and FIG. 16 is a planar perspective view showing an electric switch connection structure including a polysilicon TFT.
An α-Si layer 40 was formed on a glass substrate 1 (OA2 glass manufactured by Nippon Electric Glass Co., Ltd.) having dimensions of 112×143×1.1 mm by a method such as low pressure chemical vapor deposition (LPCVD) (FIG. 14(a)). Then, crystallization annealing was performed by applying an excimer laser such as a KrF (248nm) laser to the α-Si layer 40 to form polysilicon (FIG. 14(b)). The polysilicon was patterned in the shape of islands by photolithography (FIG. 14(c)). An insulating gate material 42 was stacked on the surfaces of the island-shaped polysilicon 41 and the substrate 1 by chemical vapor deposition (CVD) or the like to form a gate oxide insulating layer 42 (FIG. 14(d)). After forming a gate electrode 43 by deposition or sputtering (FIG. 14(e)), the gate electrode 43 was patterned and anodic oxidation was performed (FIGS. 14(f) to 14(h)). Then, doped regions (active layer) were formed by ion doping (ion implantation) to form a source 45 and a drain 47 to obtain a polysilicon TFT (FIG. 14(i)). The gate electrode 43 (and scan electrode 50 and bottom electrode of capacitor 57 shown in FIG. 15) was formed from Al, and the source 45 and the drain 47 of the TFT were of n⁺- type.

After forming an interlayer dielectric (SiO₂) having a thickness of 500 nm on the active layer by a CRCVD method, a signal electrode 51, a common electrode 52, and a capacitor upper electrode (Al) were formed, a source electrode of a second transistor (Tr2) 56 was connected with the common electrode, and the drain of a first transistor (Tr1) 55 was connected with the signal electrode (FIGS. 15 and 16). The TFT and the electrode were connected by appropriately opening the interlayer dielectric SiO₂ by wet etching using hydrofluoric acid.
Then, Al and ITO (indium tin oxide) were deposited by sputtering to thicknesses of 2000 angstroms and 1300 angstroms, respectively. A positive-type resist ("HPR204" manufactured by Fuji Photo Film Arch Co., Ltd.) was applied to the substrate by spin coating, and ultraviolet rays were applied through a photomask for forming a 90×320µm dot-shaped pattern. The resist was then developed using a tetramethylammonium hydroxide (TMAH) developer and baked at 130°C to obtain a resist pattern.
The exposed ITO was etched using an ITO etchant containing 47% hydrobromic acid, and the Al was etched using an Al enchant containing phosphoric acid/acetic acid/nitric acid. The resist was treated with a stripper containing ethanolamine as the major component ("N303" manufactured by Nagase & Company, Ltd.) to obtain a Al/ITO pattern (lower electrode: anode).
In this step, the second transistor Tr2 56 and the lower electrode 10 were connected through an opening 59 (FIG. 12).
As a second interlayer dielectric, a negative-type resist ("V259PA" manufactured by Nippon Steel Chemical Co., Ltd.) was applied by spin coating, irradiated with ultraviolet rays, and developed using a tetramethylammonium hydroxide (TMAH) developer. The resulting resist was baked at 180°C to form an interlayer dielectric of an organic film which covered the edge of the Al/ITO (ITO opening was 70×200 µm).

### (2-2) Fabrication of organic EL device

The substrate on which the interlayer dielectric was formed was subjected to ultrasonic cleaning in pure water and isopropyl alcohol, dried by air blowing, and subjected to UV cleaning.
The TFT substrate was transferred to an organic deposition device (manufactured by ULVAC, Inc.) and secured on a substrate holder. Molybdenum heating boats were each charged in advance with 4,4',4"-tris[N-(3-methylphenyl)-N-phenylamino]triphenylamine (MTDATA) and 4,4'-bis[N-(1-naphthyl)-N-phenylamino]biphenyl (NPD) as a hole injecting material, 4,4'-bis(2,2-diphenylvinyl)biphenyl (DPVBi) as a host of an emitting material, 1,6-bis(diphenylamino)pyrene (DPAP) as a dopant, and tris(8-quinolinol)aluminum (Alq) and Li as an electron injecting material and a cathode. An IZO (indium zinc oxide) target was placed in another sputtering vessel as a cathode lead electrode.

After reducing the pressure inside the vacuum vessel to 5×10⁻⁷ torr, the layers from the hole injecting layer to the cathode were stacked as described below without breaking the vacuum.
As the hole injecting layer, MTDATA was deposited to a thickness of 60 nm at a deposition rate of 0.1 to 0.3 nm/sec and NPD was deposited to a thickness of 20 nm at a deposition rate of 0.1 to 0.3 nm/sec. As the emitting layer, DPVBi and DPAP were co-deposited to a thickness of 50 nm at a deposition rate of 0.1 to 0.3 nm/sec and 0.03 to 0.05 nm/sec, respectively. As the electron-injecting layer, Alq was deposited to a thickness of 20 nm at a deposition rate of 0.1 to 0.3 nm/sec. As the cathode, Alq and Li were co-deposited to a thickness of 20 nm at a deposition rate of 0.1 to 0.3 nm/sec and 0.005 nm/sec, respectively.
Then, the substrate was transferred to the sputtering vessel, and IZO was deposited to a thickness of 200 nm at a deposition rate of 0.1 to 0.3 nm/sec as the lead electrode of the cathode to fabricate an organic EL device (a blue-green color emitting device).

### (2-3) Formation of passivation layer and organic EL device substrate

Next, as a passivation layer, a transparent inorganic film SiOₓN_{y} (O/O+N=50%: atomic ratio) was deposited on the upper electrode of an organic EL device by low-temperature CVD in a thickness of 200 nm. An organic EL device substrate was thus obtained.

### (3) Production of emitting apparatus

The organic EL device substrate produced in (2) and the color conversion substrate produced in (1) were moved into a dry box where dry nitrogen was flown and a cation type light curing adhesive (3102, manufactured by Three Bond) was applied around an display part (emitting part) of the organic EL device substrate using a dispenser.
Thereafter, the organic EL device substrate and the color conversion substrate were positioned and attached by a light irradiation. The display part was filled with an inert fluid (fluorohydrocarbon: FC70, manufactured by 3M) which had been degassed in advance to produce an organic EL emitting apparatus.

### (4) Evaluation of organic EL device

A voltage was applied across a lower electrode (ITO/A1) and an upper electrode (IZO) corresponding to each pixel (color pixel) of the organic EL emitting apparatus (lower electrode: (+), upper electrode: (-)) and adjusted such that the chromaticity was D93 (0.28, 0.29) when all the devices emitted light. The luminance and chromaticity were measured using a chroma meter (CS100, manufactured by Minolta).
The current density ratio of blue, green and red pixels (luminance ratio of devices corresponding to the individual pixels) was 1:0.97:1.04 and a burden of the devices corresponding to the individual pixels was almost equal. This showed that an emitting apparatus with well-balanced white color was obtained.

A color reproducibility range of the organic EL apparatus was 86% in terms of NTSC ratio. When the entire surface of the apparatus emitted light, the luminance was 145 nit. For the organic EL apparatus, since the luminance of an apparatus without stacking a color conversion substrate (with an organic EL device only) was 300 nit, the color conversion substrate had a conversion efficiency (white color conversion efficiency) of 48%. High color reproducibility was achieved while maintaining high efficiency.
Further, color changes were observed from the beginning when the entire surface of the organic EL apparatus emitted light at 85°C for 1000 hours. The color changes in CIE chromaticity were within Δ0.01.

### Example 2

A color conversion substrate was formed in the same manner as in Example 1 except for the following. After forming a red fluorescent layer, the material of Preparation Example 5 as a material for a green fluorescent layer was applied by spin coating, exposed to ultraviolet rays on a green color filter, developed using a 2% sodium carbonate aqueous solution and baked at 180°C to obtain a green fluorescent layer pattern on the green color filter (thickness: 12 µm). The grinding was not performed.
An organic EL device was fabricated and an emitting apparatus was produced in the same manner as in Example 1.

As a result of evaluation in the same manner as in Example 1, the current density ratio of blue, green and red pixels was 1:1:1.05 and a burden of the devices corresponding to the individual pixels was almost equal. This showed that an emitting apparatus with well-balanced white color was obtained.
A color reproducibility range of the organic EL apparatus was 81% in terms of NTSC ratio. When the entire surface of the apparatus emitted light, the luminance was 145 nit. For the organic EL apparatus, since the luminance of an apparatus without stacking a color conversion substrate (with an organic EL device only) was 300 nit, the color conversion substrate had a conversion efficiency (white color conversion efficiency) of 48%. High color reproducibility was achieved while maintaining high efficiency.
Further, color changes were observed from the beginning when the entire surface of the organic EL apparatus emitted light at 85°C for 1000 hours. The color changes in CIE chromaticity were within Δ0.01.

### Example 3

A color conversion substrate was formed in the same manner as in Example 1 except for the following. After forming a red fluorescent layer, the material of Preparation Example 4 as a material for a green fluorescent layer was applied by spin coating, exposed to ultraviolet rays on a green color filter, developed using a 2% sodium carbonate aqueous solution and baked at 180°C to obtain a green fluorescent layer pattern on the green color filter (thickness: 12 µm). The grinding was not performed.
An organic EL device was fabricated and an emitting apparatus was produced in the same manner as in Example 1.

As a result of evaluation in the same manner as in Example 1, the current density ratio of blue, green and red pixels was 1:0.96:1.04 and a burden of the devices corresponding to the individual pixels was almost equal. This showed that an emitting apparatus with well-balanced white color was obtained.
A color reproducibility range of the organic EL apparatus was 84% in terms of NTSC ratio. When the entire surface of the apparatus emitted light, the luminance was 147 nit. For the organic EL apparatus, since the luminance of an apparatus without stacking a color conversion substrate (with an organic EL device only) was 300 nit, the color conversion substrate had a conversion efficiency (white color conversion efficiency) of 48%. High color reproducibility was achieved while maintaining high efficiency.

Color changes were observed from the beginning when the entire surface of the organic EL apparatus emitted light at 85°C. After 550 hours the color changes in CIE chromaticity were within Δ0.01.
The reason for the color changes being greater than in Example 1 was that the color changes of emission from the green fluorescent layer became great because a transparent medium having an ethylene unsaturated bond was used for the transparent medium of the green fluorescent layer.

### Example 4

A green fluorescent layer was formed before a red fluorescent layer was formed in Example 3. Specifically, the material of Production Example 4 as a material for the green fluorescent layer was applied by spin coating, exposed to ultraviolet rays on a green color filter, developed using a 2% sodium carbonate aqueous solution and baked at 200°C to obtain a green fluorescent layer pattern on the green color filter (thickness: 12 µm). Next the red fluorescent layer was formed to form a color conversion substrate.
An organic EL device was fabricated and an emitting apparatus was produced in the same manner as in Example 1.

As a result of evaluation in the same manner as in Example 1, the current density ratio of blue, green and red pixels was 1:1.05:1.09 and a burden of the devices corresponding to the individual pixels was almost equal. This showed that an emitting apparatus with well-balanced white color was obtained.
A color reproducibility range of the organic EL apparatus was 80% in terms of NTSC ratio. When the entire surface of the apparatus emitted light, the luminance was 142 nit. For the organic EL apparatus, since the luminance of an apparatus without stacking a color conversion substrate (with an organic EL device only) was 300 nit, the color conversion substrate had a conversion efficiency (white color conversion efficiency) of 47%. The efficiency and the color reproducibility were slightly decreased compared to Example 3.
The reason was as follows. The green fluorescent layer containing an organic fluorescent material was formed before the red fluorescent layer containing a semiconductor nanocrystal. As a result, the efficiency and chromaticity of the green fluorescent layer decreased because of the thermal history.

### Example 5

A color conversion substrate was formed in the same manner as in Example 1 except for the following. The material of Preparation Example 2 as a material for a green fluorescent layer was applied, exposed to ultraviolet rays on a green color filter, developed using a 2% sodium carbonate aqueous solution and baked at 200°C to obtain a green fluorescent layer pattern on the green color filter (thickness: 12 µm).
Next, the material of Preparation Example 6 as a material for a red fluorescent layer was applied by spin coating, exposed to ultraviolet rays on a red color filter, developed using a 2% sodium carbonate aqueous solution and baked at 180°C to obtain a red fluorescent layer pattern on the red color filter (thickness: 12 µm). The grinding was not performed.

An organic EL device (white emission device) was fabricated in the same manner as in Example 1 except that when an emitting layer of an organic EL device was deposited, DPVBi and DPAP were co-deposited; thereafter, DPVBi and rubrene were co-deposited at a deposition rate of 0.1 to 0.3 nm/sec. and 0.03 to 0.05 nm/sec. respecively to form a 50 nm thick film.
An emitting apparatus was produced in the same manner as in Example 1.

A voltage was applied across a lower electrode (ITO/Al) and an upper electrode (IZO) corresponding to each pixel (color pixel) of the organic EL emitting apparatus (lower electrode: (+), upper electrode: (-)) and adjusted such that the chromaticity was D65 (0.31, 0.33) when all the devices emitted light. The luminance and chromaticity were measured using a chroma meter (CS100, manufactured by Minolta).
The current density ratio of blue, green and red pixels was 1:0.90:1.05 and a burden of the devices corresponding to the individual pixels was almost equal. This showed that an emitting apparatus with well-balanced white color was obtained.

### Comparative Example 1

A color conversion substrate was formed in the same manner as in Example 1 except for the following. After forming a red fluorescent layer, the material of Preparation Example 2 as a material for a green fluorescent layer was applied by spin coating, exposed to ultraviolet rays on a green color filter, developed using a 2% sodium carbonate aqueous solution and baked at 180°C to obtain a green fluorescent layer pattern on the green color filter (thickness: 12 µm). The grinding was not performed.
An organic EL device was fabricated and an emitting apparatus was produced in the same manner as in Example 1.

As a result of evaluation in the same manner as in Example 1, the current density ratio of blue, green and red pixels was 1:2.06:1.36 and a burden of the green devices was particularly large. The emitting apparatus exhibited badly-balanced white color.

### Comparative example 2

A color conversion substrate, an organic EL device and an organic EL apparatus were fabricated in the same manner as in Example 3 except that the material of Preparation Example 6 was used for a red fluorescent layer.

As a result of evaluation in the same manner as in Example 1, the current density ratio of blue, green and red pixels was 1:0.98:2.37 and a burden of the red devices was particularly large. The emitting apparatus exhibited badly-balanced white color.
The evaluation results of the emitting apparatus fabricated in the above examples and comparative examples are shown in Table 1.

### Example 6 (White emitting apparatus)

A glass substrate, 25 mm x 75 mm x 1.1 mm thick, having an ITO transparent electrode (manufactured by Geomatics Co.) was prepared. The fluorescent layer of Example 2 was arranged on the surface opposite to the ITO film of the substrate to obtain a color conversion substrate without color filters. The area ratio of parts with no fluorescent layer, with a green fluorescent layer and with a red fluorescent layer on the substrate was 3:2:7.
Next, the substrate was subjected to ultrasonic cleaning for five minutes in isopropyl alcohol, and then ITO was subjected to UV ozone cleaning for 30 minutes. The cleaned substrate on which the lower electrode was formed was mounted in a substrate holder of a vacuum deposition system.
First, the following compound (HI) film functioning as a hole-injecting layer was deposited to a thickness of 25 nm on the ITO electrode. Following the HI film formation, the following compound (HT) film functioning as a hole-transporting layer was deposited to a thickness of 10 nm. Following the HT film formation, the following compound (BH) and compound (BD) as a blue color emitting layer were co-deposited to a thickness of 10 nm with a thickness ratio of 10:0.5.
A 10 nm thick tris(8-quinolinol)aluminum film (referred to as Alq film hereinafter) was formed as an electron transporting layer on this film. Then, LiF was deposited to a thickness of 1 nm as an electron-injecting layer and Al was further deposited to a thickness of 150 nm to fabricate a blue light emitting organic EL device.
An emission spectrum of the device was measured and a luminescence peak was found at 457 nm in a blue area.

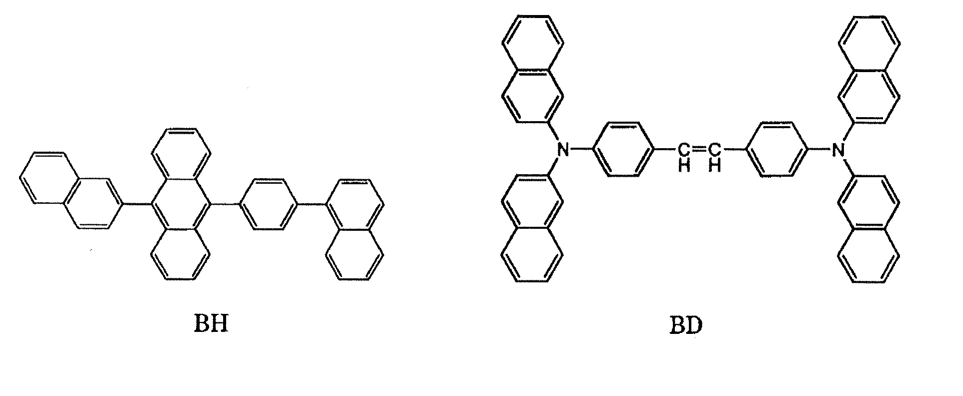

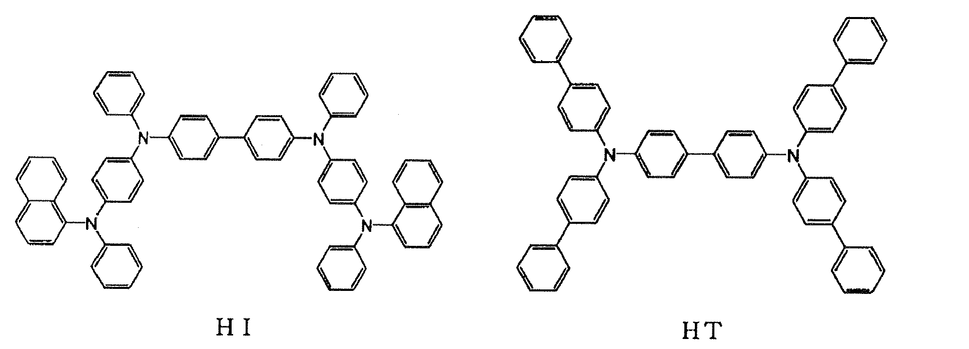

The 0.3 mm thick (mentioned above) glass substrate was attached on the organic EL device using an adhesive to seal the organic EL device. An emitting apparatus was thus obtained.

A DC voltage of 7V was applied to the ITO electrode and A1 electrode of the apparatus (ITO electrode: (+), Al electrode: (-)). A white emission was obtained.
The luminance ratio of the organic EL device as a light source to the white emitting apparatus, in other words, white conversion efficiency was 100%.
The luminance and chromaticity of the emission obtained were measured using a chroma meter (CS100, manufactured by Minolta). The CIE chromaticity coordinates were X=0.29, Y=0.31 and the color temperature was 8570K.
Further, a luminance improvement film (No.8141, manufactured by 3M) was attached to the outermost layer (fluorescent layer) on the light outcoupling side. The white conversion efficiency was then improved to 145 % and the emission uniformity in the surface was also improved.

### Comparative example 3

YAG:Ce bulk particles (YAG: yttrium aluminum garnet, a particle size from 1 to 15 µm) were dispersed in an epoxy resin (Araldite, manufactured by 3M) as a binder resin at a solid concentration of 60 wt% to prepare a fluorescent material. The material was applied to the surface opposite to the ITO on the glass substrate of blue organic EL device of Example 6 to form a fluorescent layer in a thickness of about 200 µm.
The fluorescent layer was opaque and a scatterer compared to the fluorescent layers in Examples 1 to 6.
A voltage of 7V was applied to the ITO electrode and Al electrode of the apparatus (ITO electrode: (+), Al electrode: (-)). Emission from the organic EL device and fluorescence from the YAG:Ce fluorescent material were mixed to obtain white emission.
The luminance ratio of the white emitting apparatus to the organic EL device as a light source, in other words, white conversion efficiency was 70 %. The efficiency was reduced compared to the example 6. It appears that light of the organic EL device could not be efficiently used since the fluorescent particles were large and the fluorescent medium was an opaque scatterer.
The chromaticity of the emission obtained were measured using a chroma meter (CS100, manufactured by Minolta). The CIE chromaticity coordinates were X=0.32, Y=0.32 and the color temperature was 6200°K.

| | Fluorescent material of red fluorescent layer | Fluorescent material of green fluorescent layer | Formation order of fluorescent layers | Color of emitting device | Chromaticity of display light in full-lighting condition (CIE_{X},CIE_{y}) | Current density ratio of emitting device in full-lighting condition (blue : green : red)* |
|---|---|---|---|---|---|---|
| Example 1 | Semiconductor nanocrystal (Preparation Example | Organic fluorescent material (Preparation example 3) | red-green | blue-green | (0.28,0.29) | (1.00:0.97:1.04) |
| Example 2 | Semiconductor nanocrystal (Preparation Example 1) | Organic fluorescent material (Preparation example 5) | red-green | blue-green | (0.28,0.29) | (1.00:1.00:1.05) |
| Example 3 | Semiconductor nanocrystal (Preparation Example 1) | Organic fluorescent material (Preparation example 4) | red-green | blue-green | (0.28,0.29) | (1.00:0.96:1.04) |
| Example 4 | Semiconductor nanocrystal (Preparation Example 1) | Organic fluorescent material (Preparation example 4) | green-red | blue-green | (0.28,0.29) | (1.00:1.05:1.09) |
| Example 5 | Organic fluorescent material (Preparation example 6) | Semiconductor nanocrystal (Preparation Example 2) | green-red | white | (0.31,0.33) | (1.00:0.90:1.05) |
| Comparative Example 1 | Semiconductor nanocrystal (Preparation Example 1) | Semiconductor nanocrystal (PreparationExample 2) | red-green | blue-green | (0.28,0.29) | (1.00:2.06:1.36) |
| Comparative Example 2 | Organic fluorescent material (Preparation example 6) | Organic fluorescent material (Preparation example 4) | red-green | blue-green | (0.28,0.29) | (1.00:0.98:2.37) |

| | | | | | | |
|---|---|---|---|---|---|---|
| * the same as the luminance ratio of emitting devices corresponding to individual pixels | | | | | | |

### INDUSTRIAL APPLICABILITY

The color conversion substrate according to the invention can be used for all industrial and consumer displays (for portable telephones, car navigation systems and indoor purposes).

## Claims

1. A color conversion substrate comprising a first fluorescent layer emitting first fluorescence and a second fluorescent layer emitting second fluorescence on a supporting substrate,
the first fluorescent layer comprising an organic fluorescent material and the second fluorescent layer comprising a semiconductor nanocrystal.

2. The color conversion substrate according to claim 1 wherein the first fluorescent layer is a green fluorescent layer and the second fluorescent layer is a red fluorescent layer.

3. The color conversion substrate according to claim 1 or 2 wherein the first fluorescent layer and the second fluorescent layer are separately arranged in a plane on the supporting substrate.

4. The color conversion substrate according to claim 3 comprising a blue color filter layer between the first fluorescent layer and the second fluorescent layer on the supporting layer.

5. The color conversion substrate according to claim 3 or 4 comprising a black matrix between the first fluorescent layer and the second fluorescent layer, or between the blue color filter layer, the first fluorescent layer, and the second fluorescent layer.

6. The color conversion substrate according to claim 1 or 2 wherein the first fluorescent layer and the second fluorescent layer are stacked on the supporting substrate.

7. The color conversion substrate according to any one of claims 1 to 6 wherein the organic fluorescent material of the first fluorescent layer comprises a perylene dye.

8. The color conversion layer according to any one of claims 1 to 7 wherein the first fluorescent layer comprises the organic fluorescent material dispersed in a transparent medium having no ethylenic unsaturated bonds.

9. The color conversion substrate according to claim 8 wherein the organic fluorescent material comprises a coumarin dye.

10. The color conversion layer according to any one of claims 1 to 9 wherein at least one of the first fluorescent layer and the second fluorescent layer, and a color filter are stacked.

11. An emitting apparatus wherein an emitting device is stacked on at least one of the first fluorescent layer and the second fluorescent layer, and the blue color filter layer on the color conversion substrate of any one of claims 1 to 10.

12. An emitting apparatus wherein the color conversion substrate of any one of claims 1 to 10 faces and is attached to an emitting device substrate with an emitting device arranged on a substrate.

13. An emitting apparatus comprising at least a first pixel and a second pixel on a supporting substrate,
the first pixel comprising a first emitting device and a first fluorescent layer emitting a first fluorescence arranged in this order, the first fluorescent layer comprising an organic fluorescent material,
the second pixel comprising a second emitting device and a second fluorescent layer emitting a second fluorescence arranged in this order, the second fluorescent layer comprising a semiconductor nanocrystal.

14. The emitting apparatus according to any one of claims 11 to 13 wherein the emitting device has an emission peak in a blue region.

15. The emitting apparatus according to any one of claims 11 to 14 wherein the emitting device is an organic electroluminescent device.

16. A method for producing the color conversion substrate of any one of claims 1 to 10 comprising the steps of:
forming a second fluorescent layer, and then
forming a first fluorescent layer.

17. The method according to claim 16 wherein the second fluorescent layer is formed by photolithography and the first fluorescent layer is formed by printing, or printing and grinding.
